# EUROPÄISCHE PATENTSCHRIFT

(11) **EP 3 548 857 B1**
(45) Veröffentlichungstag und Bekanntmachung des Hinweises auf die Patenterteilung: **29.06.2022**
(21) Anmeldenummer: 17778307.3
(22) Anmeldetag: 05.10.2017
(51) Int. Cl.: G01L 5/167, G01L 1/16, H01L 41/113, H01L 41/083

(54) **MESSWERTAUFNEHMER ZUM GLEICHZEITIGEN MESSEN EINER KRAFT, DIE SOWOHL DYNAMISCH ALS AUCH STATISCH SEIN KANN**
MEASUREMENT ELEMENT FOR SIMULTANEOUSLY MEASURING A FORCE WHICH CAN BE BOTH DYNAMIC AS WELL AS STATIC
TRANSDUCTEUR DESTINÉ À MESURER SIMULTANÉMENT UNE FORCE QUI PEUT ÊTRE TANT DYNAMIQUE QUE STATIQUE

(30) Priorität: 30.11.2016 EP 16201405
(43) Veröffentlichungstag der Anmeldung: 09.10.2019
(73) Patentinhaber: Kistler Holding AG, 8408 Winterthur (CH)
(72) Erfinder: CAVALLONI, Claudio, 8105 Regensdorf (CH); PFLUGER, Kim, 8404 Winterthur (CH)
(86) Internationale Anmeldenummer: PCT/EP2017/075308
(87) Internationale Veröffentlichungsnummer: WO 2018/099633

(56) Entgegenhaltungen:
- EP-A1- 0 065 511
- WO-A1-2015/139149
- WO-A2-2012/164016
- DE-A1- 3 705 471
- US-A- 4 546 658

## Beschreibung

### Technisches Gebiet

Die Erfindung betrifft einen Messwertaufnehmer zum gleichzeitigen Messen einer Kraft, die sowohl dynamisch als auch statisch sein kann, nach dem Oberbegriff des unabhängigen Anspruchs.

### Stand der Technik

Zum Messen einer dynamischen Kraft zeigt die Schrift EP0065511A1 einen Messwertaufnehmer mit einem piezoelektrischen Sensorelement. Das piezoelektrische Sensorelement weist mehrere scheibenförmige Plättchen aus piezoelektrischem Material auf, mit einem Scheibendurchmesser der Plättchen, der wesentlich grösser als eine Dicke der Plättchen ist. Zum Messen der Kraft wird der direkte piezoelektrische Effekt in Form des Longitudinaleffektes angewendet. Das piezoelektrische Material ist räumlich so zur Kraft orientiert, dass die Kraft normal auf Scheibenflächen der Plättchen einwirkt und auf den Scheibenflächen elektrische Polarisationsladungen erzeugt. Die elektrischen Polarisationsladungen werden von Elektroden abgenommen und als Ladungssignale an eine Auswerteeinheit abgeleitet. Die elektrischen Polarisationsladungen sind proportional zur wirkenden Kraft. Aufgrund von praktisch immer vorhandenen elektrischen Leckströmen ist mit dem direkten piezoelektrischen Effekt nur das Messen einer dynamischen Kraft mit Änderungsfrequenzen im Bereich von einigen Hz bis mehreren MHz möglich, quasistatische Kraftmessungen von einigen Minuten Dauer sind möglich.

Im Unterschied dazu ändert sich eine statische Kraft auch über lange Zeiträume von Stunden, Wochen und Jahren nicht. Zum Messen einer statischen Kraft lehrt der Messwertaufnehmer der Schrift EP0065511A1 die Anwendung des inversen piezoelektrischen Effektes. Ein weiteres piezoelektrisches Sensorelement weist mehrere scheibenförmige Plättchen aus piezoelektrischem Material auf, an welche über Elektroden ein elektrisches Wechselfeld als Frequenzsignale angelegt wird. Das elektrische Wechselfeld regt die Plättchen mittels des inversen piezoelektrischen Effektes zu mechanischen Schwingungen an. Das elektrische Wechselfeld ist durchstimmbar und wird von der Auswerteeinheit erzeugt. Wenn eine Anregungsfrequenz des elektrischen Wechselfeldes gleich einer mechanischen Eigenfrequenz der Plättchen ist, liegt Resonanz vor, die entsprechende Frequenz wird Resonanzfrequenz genannt. Unter der Wirkung der statischen Kraft ändert sich die Resonanzfrequenz der Plättchen, welche Frequenzänderung von einer Oszillatorschaltung der Auswerteeinheit erfasst wird. Das Messen der dynamischen Kraft und der statischen Kraft erfolgt gemäss der Lehre der Schrift EP0065511A1 gleichzeitig.

Aufgabe der Erfindung ist es, den Messwertaufnehmer aus dem Stand der Technik zum gleichzeitigen Messen einer Kraft, die sowohl dynamisch als auch statisch sein kann, zu verbessern.

### Darstellung der Erfindung

Diese Aufgabe wird durch die Merkmale des unabhängigen Anspruchs gelöst.

Die Erfindung betrifft einen Messwertaufnehmer zum gleichzeitigen Messen einer Kraft, die sowohl dynamisch als auch statisch sein kann; mit mindestens einem piezoelektrischen Aufnehmerelement, wobei die Kraft auf Elementflächen des piezoelektrischen Aufnehmerelementes elektrische Polarisationsladungen erzeugt, eine Menge der erzeugten elektrischen Polarisationsladungen ist proportional zu einer Grösse der Kraft; mit einem Resonatorelement, welches zu mindestens einer Resonanzfrequenz anregbar ist; wobei die Kraft in einer Kraftrichtung am piezoelektrischen Aufnehmerelement und am Resonatorelement angreift; wobei die Kraft im Resonatorelement eine Querdehnung verursacht, die Querdehnung erfolgt im Resonatorelement in einer Querrichtung, welche Querrichtung mit der Kraftrichtung einen von Null verschiedenen Winkel bildet, eine Grösse der Querdehnung ist proportional zur Grösse der Kraft; und wobei die Querdehnung eine Frequenzänderung der Resonanzfrequenz erzeugt, welche Frequenzänderung eine Funktion der Kraft ist.

Die Schrift EP0065511A1 lehrt die Verwendung von zwei piezoelektrischen Sensorelementen für das gleichzeitige Messen einer dynamischen Kraft und einer statischen Kraft. Die beiden piezoelektrischen Sensorelemente sind in gleicher räumlicher Ausrichtung zur zu messenden Kraft angeordnet und werden von der zu messenden Kraft in gleicher Weise beeinflusst. Die Messprinzipien sind jedoch unterschiedlich. Zum Messen der dynamischen Kraft wird der direkte piezoelektrische Effekt verwendet, zum Messen der statischen Kraft wird eine Frequenzänderung einer Resonanzfrequenz verwendet. Eine mechanische Schwingungsanregung erfolgt mittels des inversen piezoelektrischen Effektes. Nun muss, damit sich der direkte piezoelektrische Effekt einstellt, ein piezoelektrischer Koeffizient ungleich Null sein. Und damit sich der inverse piezoelektrische Effekt einstellt, muss ein piezoelektrischer Modul ungleich Null sein. Zwar kann man piezoelektrisches Material der piezoelektrischen Sensorelemente räumlich so ausrichten, dass sich sowohl der direkte piezoelektrische Effekt als auch der inverse piezoelektrische Effekt einstellt, jedoch sind die piezoelektrischen Effekte dann nur schwach ausgeprägt und die im Markt geforderte hohe Empfindlichkeit des direkten piezoelektrischen Effektes wird nicht erreicht.

Auch ist der Messwertaufnehmer der Schrift EP0065511A1 mechanisch vorgespannt. Die mechanische Vorspannung verhindert das Auftreten von elektrischen Kontaktwiderständen zwischen dem piezoelektrischen Material und den Elektroden beim Messen der Frequenzänderung der Resonanzfrequenz. Allerdings dämpft die mechanische Vorspannung auch die mechanischen Schwingungen. Der Messwertaufnehmer hat deshalb einen hohen Verlustfaktor, was nicht den Marktbedürfnissen entspricht.

Daher weist der erfindungsgemässe Messwertaufnehmer ein piezoelektrisches Aufnehmerelement und ein Resonatorelement auf, welche sich beide unabhängig voneinander räumlich so zueinander und zur zu erfassenden Kraft anordnen lassen, dass die Nachteile der Schrift EP0065511A1 überwunden werden. Das piezoelektrische Aufnehmerelement misst die Kraft direkt im Kraftfluss, während das Resonatorelement in einem Schwingbereich ausserhalb des Kraftflusses eine von der Kraft verursachte Querdehnung misst. Somit lässt sich das piezoelektrische Aufnehmerelement gezielt mit hoher Empfindlichkeit bezüglich der Kraftrichtung anordnen. Unabhängig davon lässt sich das Resonatorelement so zur Querdehnung anordnen, dass es in einem Schwingbereich genügend Raum zum Schwingen hat und der Messwertaufnehmer somit einen hohen Gütefaktor aufweist.

### Kurze Beschreibung der Zeichnungen

Im Folgenden wird die Erfindung beispielhaft unter Beizug der Figuren näher erklärt. Es zeigen
- Fig. 1: eine schematische Explosivdarstellung eines Teils eines Messwertaufnehmers;
- Fig. 2: eine Ansicht in Perspektive eines Teils einer ersten Ausführungsform des Messwertaufnehmers nach Fig. 1 mit einem piezoelektrischen Aufnehmerelement;
- Fig. 3: einen Schnitt durch einen Teil der ersten Ausführungsform eines Messwertaufnehmers nach Fig. 2;
- Fig. 4: eine Ansicht in Perspektive eines Teils einer zweiten Ausführungsform des Messwertaufnehmers nach Fig. 1 mit zwei piezoelektrischen Aufnehmerelementen;
- Fig. 5: einen Schnitt durch einen Teil der zweiten Ausführungsform eines Messwertaufnehmers nach Fig. 4;
- Fig. 6: eine Ansicht in Perspektive eines Teils einer dritten Ausführungsform des Messwertaufnehmers nach Fig. 1 mit einem piezoelektrischen Aufnehmerelement;
- Fig. 7: einen Schnitt durch einen Teil der dritten Ausführungsform eines Messwertaufnehmers nach Fig. 6;
- Fig. 8: eine Ansicht in Perspektive eines Teils einer vierten Ausführungsform des Messwertaufnehmers nach Fig. 1 mit zwei piezoelektrischen Aufnehmerelementen;
- Fig. 9: einen Schnitt durch einen Teil der vierten Ausführungsform eines Messwertaufnehmers nach Fig. 8;
- Fig. 10: eine erste Darstellung einer mittleren Kraftempfindlichkeit eines Resonatorelementes des Messwertaufnehmers nach Fig. 1 bis 9 in Abhängigkeit eines Krafteinleitungswinkels;
- Fig. 11: eine zweite Darstellung der mittleren Kraftempfindlichkeit eines Resonatorelementes des Messwertaufnehmers nach Fig. 1 bis 9 in Abhängigkeit von Krafteinleitungswinkelbereichen;
- Fig. 12: eine perspektivische Ansicht einer ersten Ausführungsform eines Kraftangriffselementes des Messwertaufnehmers nach Fig. 1 bis 9;
- Fig. 13: eine perspektivische Ansicht einer zweiten Ausführungsform eines Kraftangriffselementes des Messwertaufnehmers nach Fig. 1 bis 9;
- Fig. 14: eine Draufsicht einer dritten Ausführungsform eines Kraftangriffselementes des Messwertaufnehmers nach Fig. 1 bis 9 mit einem ersten Krafteinleitungswinkelbereich;
- Fig. 15: eine Draufsicht einer vierten Ausführungsform eines Kraftangriffselementes des Messwertaufnehmers nach Fig. 1 bis 9 mit einem zweiten Krafteinleitungswinkelbereich;
- Fig. 16: einen Schnitt durch einen Teil des Messwertaufnehmers nach Fig. 2 oder 3 mit einem Kraftangriffselement nach Fig. 14 oder 15;
- Fig. 17: einen Schnitt durch einen Teil des Messwertaufnehmers nach Fig. 8 oder 9 mit zwei Kraftangriffselementen nach Fig. 14 oder 15;
- Fig. 18: eine erste Darstellung eines mittleren thermischen Längenausdehnungskoeffizienten eines Resonatorelementes des Messwertaufnehmers nach Fig. 1 bis 9 in Abhängigkeit eines Krafteinleitungswinkels;
- Fig. 19: eine zweite Darstellung des mittleren thermischen Längenausdehnungskoeffizienten eines Resonatorelementes des Messwertaufnehmers nach Fig. 1 bis 9 in Abhängigkeit von Krafteinleitungswinkelbereichen; und
- Fig. 20: eine Ansicht einer Ausführungsform eines einsatzbereit montierten Messwertaufnehmers nach Fig. 1 bis 9 mit einem Kraftangriffselement nach Fig. 14 oder 15.

### Wege zur Ausführung der Erfindung

Der Messwertaufnehmer 1 ist zum gleichzeitigen Messen einer Kraft F vorgesehen, die sowohl dynamisch als auch statisch sein kann. Eine dynamische Kraft F ändert sich in kurzen Zeiträumen und weist Änderungsfrequenzen im Bereich von einigen Hz bis mehreren MHz auf. Eine statische Kraft F ändert sich über lange Zeiträume von Stunden, Wochen und Jahren nicht und weist Änderungsfrequenzen im Bereich von mHz bis nHz auf. Ob die zu erfassende Kraft F dynamisch oder statisch ist, hängt einzig von ihrer Änderungsfrequenz ab. Bei Kenntnis der vorliegenden Erfindung kann der Fachmann den Messwertaufnehmer auch zum gleichzeitigen Messen eines dynamischen Druckes und eines statischen Druckes vorsehen. Auch kann der Fachmann den Messwertaufnehmer zum Messen einer Beschleunigung vorsehen.

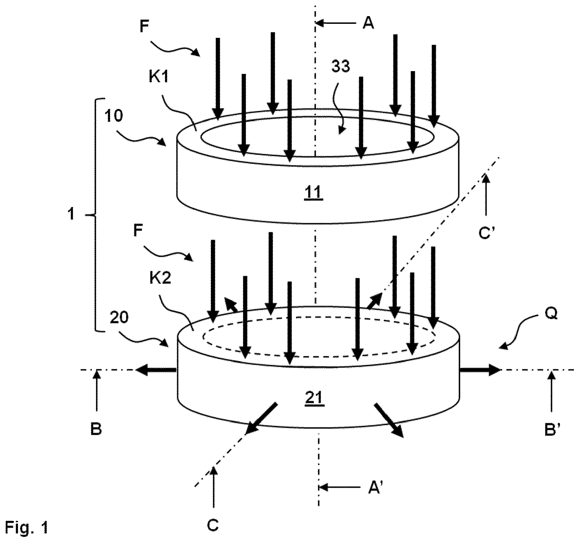

Der Messwertaufnehmer 1 weist eine Längsachse AA', eine Querachse BB' und eine Schrägachse CC' auf. Die Achsen stehen schräg aufeinander, vorzugsweise stehen sie senkrecht aufeinander. Im Sinne der Erfindung wird mit dem Adjektiv schräg jeder von Null verschiedene Winkel gemeint, unter dem die Achsen aufeinander stehen. Die Längsachse AA' steht senkrecht auf einer Querebene BC. Die Fig. 1 bis 9 zeigen mehrere Ausführungsformen eines Messwertaufnehmers 1 mit mindestens einem piezoelektrischen Aufnehmerelement 10, 10', welches eine Kraft F mittels des direkten piezoelektrischen Effektes misst und mit einem Resonatorelement 20, welches eine Querdehnung Q mittels einer Frequenzänderung einer Resonanzfrequenz misst. Die Kraft F und die Querdehnung Q sind schematisch als Pfeile dargestellt.

Die Kraft F wird in den Messwertaufnehmer 1 in einer Kraftrichtung eingeleitet, die parallel zur Längsachse AA' ist. Im Sinne der Erfindung wird auch von der Kraftrichtung AA' gesprochen. Die Kraft F greift in mindestens einem Aufnehmerkontaktbereich K1, K1' am piezoelektrischen Aufnehmerelement 10, 10' an, der Aufnehmerkontaktbereich K1, K1' liegt im Kraftfluss. Die Kraft F kann direkt oder indirekt am piezoelektrischen Aufnehmerelement 10, 10' angreifen. Die Kraft F greift in mindestens einem Resonatorkontaktbereich K2, K2' am Resonatorelement 20 an, auch der Resonatorkontaktbereich K2, K2' liegt im Kraftfluss. Die Kraft F kann direkt oder indirekt am Resonatorelement 20 angreifen. In den Ausführungsformen nach Fig. 1 bis 9 ist das piezoelektrische Aufnehmerelement 10, 10' über den Resonatorkontaktbereich K2, K2' im mechanischen Kontakt mit dem Resonatorelement 20.

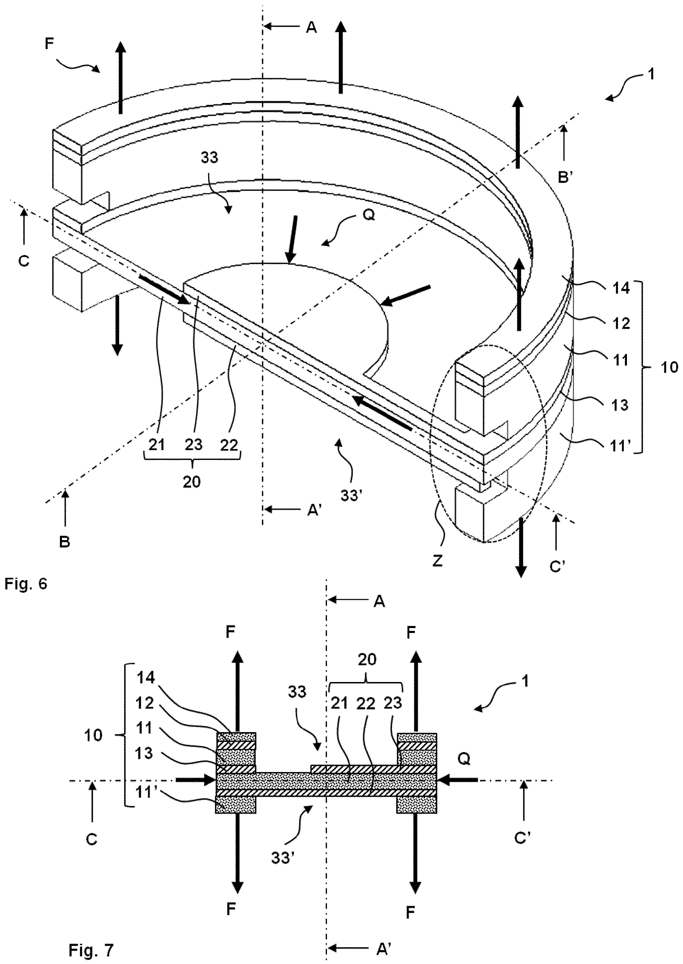

Das piezoelektrische Aufnehmerelement 10, 10' misst die Kraft F direkt im Kraftfluss, während das Resonatorelement 20 die von der Kraft F verursachte Querdehnung Q in einem Schwingbereich misst, der ausserhalb des Kraftflusses liegt. Die Kraft F verursacht eine elastische Verformung des Resonatorelementes 20. Die elastische Verformung des Resonatorelementes 20 ist eine Funktion der Kraft F, vorzugsweise ist sie proportional zur Grösse der Kraft F. Im Resonatorelement 20 treten entlang der Längsachse AA' eine Längenänderung und in der Querebene BC die Querdehnung Q auf. Eine Grösse der Querdehnung Q ist eine Funktion der Kraft, vorzugsweise ist sie proportional zur Grösse der Kraft F. In den Ausführungsformen nach Fig. 1 bis 5 ist die Kraft F eine Drucckraft, in den Ausführungsformen nach Fig. 6 bis 9 ist die Kraft F eine Zugkraft. Die Querdehnung Q kann isotrop oder anisotrop sein. Gerade bei piezoelektrischem Material ist die Querdehnung Q anisotrop.

Das piezoelektrische Aufnehmerelement 10, 10' ist hohlzylinderförmig (Ring, Hülse, usw.). Das Resonatorelement 20 ist zylinderförmig (Scheibe, Rundstab, usw.). Die Längsachse AA' durchdringt das piezoelektrische Aufnehmerelement 10, 10' und das Resonatorelement 20 zentral. Bei Kenntnis der vorliegenden Erfindung kann der Fachmann auch andere bekannte Formen von piezoelektrischen Aufnehmerelementen und von Resonatorelementen wie Polyeder, Würfel, Quader, Hohlkegelstumpfe, Halbscheiben, Viertelscheiben, usw. realisieren.

Das piezoelektrische Aufnehmerelement 10, 10' besteht aus piezoelektrischem Material 11, 11'. Das piezoelektrische Material 11, 11' ist Kristallmaterial wie Quarz (SiO₂ Einkristall), Calcium-Gallo-Germanat (Ca₃Ga₂Ge₄O₁₄ oder CGG), Langasit (La₃Ga₅SiO₁₄ oder LGS), Turmalin, Galliumorthophosphat, sowie Piezokeramik, usw. Vorzugsweise besteht das piezoelektrische Material 11, 11' aus Kristallmaterial einer Symmetrieklasse m, 32, 3m, 42m, 2m oder 23. Vorzugsweise wird Quarz als piezoelektrisches Material 11, 11' verwendet, mit den orthogonalen Achsen x, y, z als Kristallachsen und der Achse z als optischer Achse. Ein Elastizitätskoeffizient s_{λµ} = (δS_{λ}/δT_{µ}) von Quarz ist in einer Ebene xy für unterschiedliche Orientierungen des piezoelektrischen Materials 11, 11' vom Betrag her gleich. Mit S_{λ} wird ein mechanischer Dehnungstensor in Matrixschreibweise bezeichnet, mit T_{µ} wird ein mechanischer Spannungstensor in Matrixschreibweise bezeichnet, mit Tensorindizes A, µ = 1 bis 6. Und auch ein thermischer Längenausdehnungskoeffizient α von Quarz ist in der Ebene xy für unterschiedliche Orientierungen des piezoelektrischen Materials 11, 11' gleich.

Die Kraft F wirkt auf das piezoelektrische Aufnehmerelement 10, 10' und erzeugt elektrische Polarisationsladungen auf Elementflächen des piezoelektrischen Aufnehmerelementes 10, 10'. Das piezoelektrische Aufnehmerelement 10, 10' ist für den direkten piezoelektrischen Effekt in Form des Longitudinaleffektes so orientiert, dass auf Stirnflächen auf denen die Kraft F einwirkt, auch elektrische Polarisationsladungen erzeugt werden. Die Stirnflächen sind somit die Elementflächen. Die Stirnflächen liegen in der Querebene BC. Damit sich der direkte piezoelektrische Effekt einstellt, muss ein piezoelektrischer Koeffizient d_{iµ} = (δDᵢ/δT_{µ}) ungleich Null sein. Mit Dᵢ wird ein elektrisches Verschiebungsfeld bezeichnet, mit T_{µ} wird ein mechanischer Spannungstensor in Matrixschreibweise bezeichnet, mit lateinischen Indizes i = 1 bis 3 und mit Tensorindizes µ = 1 bis 6. Eine Empfindlichkeit gibt an, wie stark das erste piezoelektrische Material 11, 11' auf die Kraft F reagiert, wie viele elektrische Polarisationsladungen die Kraft F erzeugt. Die Empfindlichkeit wird vom piezoelektrischen Koeffizienten d_{iµ} = (δDᵢ/δT_{µ}) bestimmt. Das piezoelektrische Material 11, 11' ist so zur Kraft F orientiert, dass es eine hohe Empfindlichkeit, vorzugsweise eine maximale Empfindlichkeit für den direkten piezoelektrischen Effekt hat. Vorzugsweise wird Quarz als piezoelektrisches Material 11, 11' verwendet, mit den orthogonalen Achsen x, y, z als Kristallachsen und der Achse z als optischer Achse. Für den Longitudinaleffekt weist der piezoelektrische Koeffizient d₁₁ eine maximale Empfindlichkeit auf, wenn das piezoelektrische Aufnehmerelement 10, 10' als x-Ring mit einer Achse x als Normale zu einer Ebene yz geschnitten ist. Die Achse x des x-Rings ist parallel zur Längsachse AA'. Die optische Achse z des x-Rings liegt in der Querebene BC. Bei Kenntnis der vorliegenden Erfindung kann der Fachmann auch den Transversaleffekt verwenden, wo das piezoelektrische Aufnehmerelement so orientiert ist, dass elektrische Polarisationsladungen auf Elementflächen erzeugt werden, die senkrecht zu den Stirnflächen sind, auf denen die Kraft F einwirkt.

Das Resonatorelement 20 kann ebenfalls aus piezoelektrischem Material 21 bestehen. Vorzugsweise sind das piezoelektrische Aufnehmerelement 10, 10' und das Resonatorelement 20 aus dem gleichen piezoelektrischem Material 11, 11', 21, wodurch die Herstellung des Messwertaufnehmers 1 kostengünstig ist und das piezoelektrische Aufnehmerelement 10, 10' und das Resonatorelement 20 weitgehend ähnliche physikalische Eigenschaften haben. Bei Kenntnis der vorliegenden Erfindung kann der Fachmann das Resonatorelement aber auch aus einem Verbund aus einem piezoelektrischem Material und einem nichtpiezoelektrischen Material wie einem Metall, einem Nichtmetall, einem Halbleiter, einem organischen Werkstoff, einem anorganischen nichtmetallischem Werkstoff, usw. bestehen. Vorzugsweise sind die beiden Materialien über Stoffschluss wie Thermokompressionsbonden, Kleben, usw. miteinander verbunden. Eine Schwingungsanregung des piezoelektrischem Materiales für zu einer mechanischen Schwingung des Verbundes.

Das Resonatorelement 20 lässt sich mit einer Anregungsfrequenz des elektrischen Wechselfeldes zu mindestens einer Resonanzfrequenz in einem Grundton und n Obertönen anregen. Resonanz liegt vor, wenn die Anregungsfrequenz gleich einer mechanischen Eigenfrequenz des Resonatorelementes 20 ist. Damit sich der inverse piezoelektrische Effekt einstellt, muss ein piezoelektrischer Modul e_{iλ} = δDᵢ/δS_{λ}) ungleich Null sein, Mit Dᵢ wird das elektrische Verschiebungsfeld bezeichnet, mit S_{λ} wird der mechanische Dehnungstensor in Matrixschreibweise bezeichnet, mit lateinischen Indizes i = 1 bis 3 und mit Tensorindizes λ = 1 bis 6. Das Resonatorelement 20 ist so orientiert, dass es als Dickenschwinger oder als Längen- oder Dehnungsschwinger oder als Biegeschwinger oder als Flächenscherschwinger oder als Dickenscherschwinger schwingt. Vorzugsweise wird das Resonatorelement 20 als Dickenscherschwinger betrieben. Als Dickenschwerschwinger ist das Resonatorelement 20 so orientiert, dass sich zwei Stirnflächen des zylinderförmigen Resonatorelementes 20 in der Querebene BC gegenläufig verschieben. Die Stirnflächen liegen in der Querebene BC.

Die Querdehnung Q erzeugt eine Frequenzänderung Δf der Resonanzfrequenz f des Resonatorelementes 20. Die Frequenzänderung Δf ist eine Funktion der Kraft F. Vorzugsweise ist die Frequenzänderung Δf proportional zur Grösse der Querdehnung Q. So kann die Frequenzänderung Δf = Q * K_{f} * (f²*η/n*D) eine Funktion von mehreren Parametern sein. Die Frequenzänderung Δf kann somit auch proportional zu einer Kraftempfindlichkeit K_{f} sein. Die Kraftempfindlichkeit K_{f} wiederum hängt von einem Krafteinleitungswinkel θ ab. Mit D wird ein Dimensionsparameter wie ein Durchmesser in der Querebene BC des piezoelektrischen Materials 21 bezeichnet. Mit η wird ein Vorrichtungsparameter bezeichnet. Vorzugsweise wird Quarz als piezoelektrisches Material 21 des Resonatorelementes 20 verwendet, mit den orthogonalen Achsen x, y, z als Kristallachsen und der Achse z als optischer Achse. Das Resonatorelement 20 ist als y-Scheibe mit der Achse y als Normale zu einer Ebene zx geschnitten und weist einen piezoelektrischen Modul e₂₆ und einen Elastizitätsmodul c₆₆ auf. Die Achse y der y-Scheibe ist parallel zur Längsachse AA'. Die optische Achse z der y-Scheibe liegt in der Querebene BC. Es ist auch möglich anstelle einer y-Scheibe eine AT-Scheibe als Resonatorelement 20 zu verwenden. Die AT-Scheibe ist in einer Ebene z'x geschnitten, mit einem Winkel von 35.25° zwischen der Achse z und einer Achse z'. Bei Kenntnis der vorliegenden Erfindung kann der Fachmann andere bekannte Schnitte in piezoelektrischem Kristallmaterial wie ein CT-Schnitt, ein GT-Schnitt, ein BT-Schnitt, ein DT-Schnitt, ein FT-Schnitt, usw. verwenden.

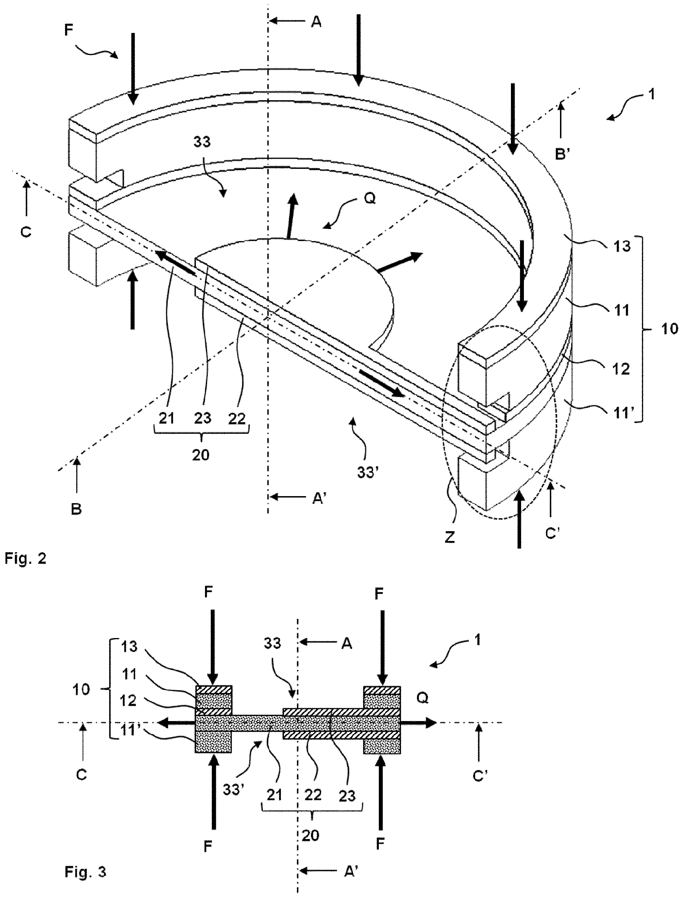

In den Ausführungsformen nach Fig. 2, 3, 6, 7 weist der Messwertaufnehmer 1 ein einziges piezoelektrisches Aufnehmerelement 10 auf. Das Resonatorelement 20 ist bezüglich der Längsachse AA' innerhalb des piezoelektrischen Aufnehmerelementes 10 angeordnet. Das Resonatorelement 20 ist räumlich zwischen einem ersten piezoelektrischen Material 11 und einem zweiten piezoelektrischen Material 11' des piezoelektrischen Aufnehmerelementes 10 angeordnet.

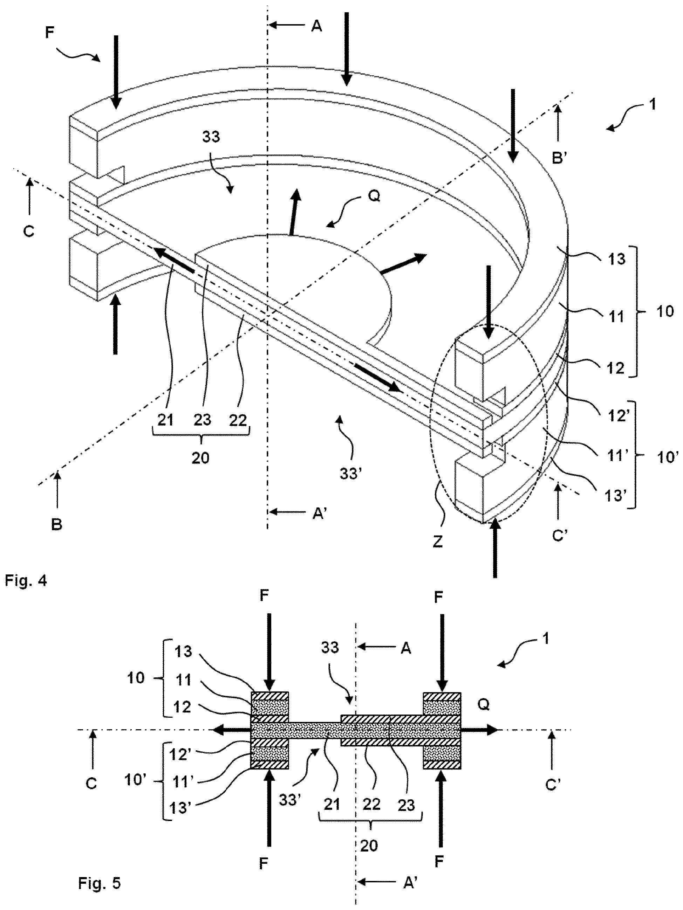

In den Ausführungsformen nach Fig. 4, 5, 8, 9 weist der Messwertaufnehmer 1 zwei piezoelektrische Aufnehmerelemente 10, 10' auf. Das Resonatorelement 20 ist bezüglich der Längsachse AA' zwischen einem ersten piezoelektrischen Aufnehmerelement 10 und einem zweiten piezoelektrischen Aufnehmerelement 10' angeordnet. Das Resonatorelement 20 ist räumlich zwischen einem ersten piezoelektrischen Material 11 des ersten piezoelektrischen Aufnehmerelementes 10 und einem zweiten piezoelektrischen Material 11' des zweiten piezoelektrischen Aufnehmerelementes 10' angeordnet. Die Empfindlichkeit des Messwertaufnehmers 1 für den direkten piezoelektrischen Effekt ist mit zwei piezoelektrische Aufnehmerelementen 10, 10' somit höher, vorzugsweise doppelt so hoch als mit einem piezoelektrischen Aufnehmerelement 10.

Für eine weitgehend symmetrische Einleitung der Kraft F in das piezoelektrische Aufnehmerelement 10, 10' und das Resonatorelement 20 weist der Messwertaufnehmer 1 einen bezüglich der Längsachse AA' symmetrischen Aufbau auf. In den Ausführungsformen nach Fig. 2 bis 9 ist das Resonatorelement 20 bezüglich der Längsachse AA' zwischen einem ersten piezoelektrischen Material 11 und einem zweiten piezoelektrischen Material 11' angeordnet. Vorzugsweise sind das erste piezoelektrische Material 11 und das zweite piezoelektrische Material 11' Gleichteile, wodurch die Herstellung des Messwertaufnehmers 1 kostengünstig ist. In den Ausführungsformen nach Fig. 2, 3, 6, 7 ist das zweite piezoelektrische Material 11' mechanisch mit dem piezoelektrischen Material 21 des Resonatorelementes 20 verbunden. Vorzugsweise erfolgt die mechanische Verbindung über Stoffschluss wie Schweissen, Diffusionsschweissen, Thermokompressionsbonden, Löten, usw. Solch eine stoffschlüssige Verbindung ist kostengünstig und mechanisch langzeitstabil.

Das Resonatorelement 20 ist bezüglich der Längsachse AA' zylinderförmig und zwischen einem hohlzylinderförmigen ersten piezoelektrischen Material 11 und einem hohlzylinderförmigen zweiten piezoelektrischen Material 11' angeordnet. Im Hohlzylinder des ersten piezoelektrischen Materials 11 ist ein erster Hohlraum 33 und im Hohlzylinder des zweiten piezoelektrischen Materials 11' ist ein zweiter Hohlraum 33' ausgebildet. Die Hohlräume 33, 33' liegen oberhalb und unterhalb des Resonatorelementes 20. Eine räumliche Ausdehnung der Hohlräume 33, 33' entlang der Längsachse AA' und in der Querebene BC ist grösser als Amplituden der mechanischen Schwingungen des Resonatorelementes 20. Das Resonatorelement 20 hat somit genügend Raum, um in den Hohlräumen 33, 33' mit hoher Güte zu schwingen. Die mechanischen Schwingungen können axial entlang der Längsachse AA' erfolgen. Die mechanischen Schwingungen können radial in der Querebene BC erfolgen. Die mechanischen Schwingungen können als Dickenscherschwingung in der Querebene BC erfolgen. Schliesslich können die mechanischen Schwingungen als Kombination einer axialen und einer radialen Schwingung oder als Kombination einer radialen Schwingung und einer Dickenscherschwingung erfolgen.

Für das Messen der Kraft F werden elektrischen Polarisationsladungen des piezoelektrischen Materials 11, 11' des piezoelektrischen Aufnehmerelementes 10, 10' von Elektroden 12, 12', 13, 13' abgenommen und als Ladungssignale an eine Auswerteeinheit abgeleitet. Die Elektroden 12, 12', 13, 13' werden auch Ladungselektroden 12, 12', 13, 13' genannt. Für das Messen der Querdehnung Q wird über Elektroden 22, 23 ein elektrisches Wechselfeld als Frequenzsignale an das piezoelektrische Material 21 des Resonatorelementes 20 angelegt. Die Elektroden 22, 23 werden auch Frequenzelektroden 22, 23 genannt. Die Elektroden 12, 12', 13, 13', 22, 23 sind dünne Schichten aus elektrisch leitfähigem Material wie aus Reinmetallen, Nickellegierungen, Kobaltlegierungen, Eisenlegierungen, usw. Die Elektroden 12, 12', 13, 13', 22, 23 sind mechanisch und elektrisch mit dem piezoelektrischen Material 11, 11', 21 verbunden. Vorzugsweise erfolgt die mechanische und elektrische Verbindung über Stoffschluss wie Schweissen, Diffusionsschweissen, Thermokompressionsbonden, Löten, usw. Solch eine stoffschlüssige Verbindung ist kostengünstig und mechanisch und elektrisch langzeitstabil.

Die Ladungselektroden 12, 12', 13, 13' sind hohlzylinderförmig und erstecken sich weitgehend vollständig über Stirnflächen des piezoelektrischen Aufnehmerelementes 10, 10'. Die Frequenzelektroden 22, 23 sind zylinderförmig und erstrecken sich in einen Schwingbereich über Stirnflächen des Resonatorelementes 20. Der Schwingbereich liegt in einem zentralen Bereich der Stirnflächen des Resonatorelementes 20, er liegt nahe an der zentral die Stirnflächen durchdringende Längsachse AA'. In einem von der Längsachse AA' radial entfernten Randbereich der Stirnflächen des Resonatorelementes 20 sind lediglich schmale elektrische Zuleitungen zu den Frequenzelektroden 22, 23 angeordnet. Im Schwingbereich des Resonatorelementes 20 wird das piezoelektrische Material 21 von den Frequenzelektroden 22, 23 zu mechanischen Schwingungen angeregt und das Resonatorelement 20 schwingt mit grosser Amplitude. Im Randbereich des Resonatorelementes 20 ist der Resonatorkontaktbereich K2, K2' angeordnet, hier wird die Kraft F in das Resonatorelement 20 eingeleitet. Im Randbereich des Resonatorelementes 20 wird das piezoelektrische Material 21 von den Frequenzelektroden 22, 23 nicht zu mechanischen Schwingungen angeregt und das Resonatorelement 20 schwingt mit geringer Amplitude, eine Grösse der Amplitude nimmt mit einem radialen Abstand zu den Frequenzelektroden 22, 23 ab. Eine radiale Ausdehnung des Randbereiches ist so gewählt, dass eine mechanische Verbindung des piezoelektrischen Aufnehmerelementes 10, 10' mit dem Resonatorelement 20 die mechanischen Schwingungen nicht oder nur in vernachlässigbar geringem Masse dämpft.

Die erste und die dritte Ausführungsform nach Fig. 2, 3, 6, 7 weist vier Elektroden 12, 13, 22, 23 auf, die zweite und die vierte Ausführungsform nach Fig. 4, 5, 8, 9 weist sechs Elektroden 12, 12', 13, 13', 22, 23 auf. In der ersten Ausführungsform nach Fig. 2, 3 ist eine Ladungselektrode 12 sowohl mit dem ersten piezoelektrischen Material 11 des piezoelektrischen Aufnehmerelementes 10 als auch mit dem piezoelektrischen Material 21 des Resonatorelementes 20 mechanisch und elektrisch verbunden. Die Ladungselektrode 12 wird auf Gegenelektrode 12 genannt. Eine Ladungselektrode 13 ist auf dem ersten piezoelektrischen Material 11 des piezoelektrischen Aufnehmerelementes 10 angeordnet und dient als elektrische Masse und wird auch Masseelektrode 13 genannt. Die Masseelementrode 13 ist mit einem geerdeten Gehäuse 41 des Messwertaufnehmers 1 elektrisch verbunden. Die Gegenelektrode 12 und die Frequenzelektroden 22, 23 sind in genau einer Kontaktierungszone Z nahe der Schrägachse CC' für eine elektrische und mechanische Kontaktierung mit elektrischen Leitern einfach zugänglich. Der Messwertaufnehmer 1 benötigt nur drei elektrische Leiter für vier Elektroden 12, 13, 22, 23.

In der zweiten Ausführungsform nach Fig. 4, 5 sind zwei Ladungselektroden 12, 12' mit dem piezoelektrischen Material 21 des Resonatorelementes 20 mechanisch verbunden. Die zwei Ladungselektroden 12, 12' sind auf verschiedenen Stirnflächen des piezoelektrischen Materials 21 des Resonatorelementes 20 angeordnet. Die beiden Ladungselektroden 12, 12' sind elektrisch miteinander verbunden und dienen als gemeinsame Gegenelektrode 12, 12'. Damit die beiden Gegenelektroden 12, 12' elektrische Polarisationsladungen mit gleichem Vorzeichen abgreifen, sind das erste piezoelektrische Material 11 des ersten piezoelektrischen Aufnehmerelementes 10 und das zweite piezoelektrische Material 11' des zweiten piezoelektrischen Aufnehmerelementes 10' mit entgegengesetzter Polarisationsrichtung zueinander angeordnet. Zwei Ladungselektroden 13, 13' sind auf dem piezoelektrischen Material 11, 11' der piezoelektrischen Aufnehmerelemente 10, 10' angeordnet und dienen als elektrische Masse und werden auch Masseelektroden 13, 13' genannt. Die beiden Masseelementroden 13, 13' sind mit dem geerdeten Gehäuse 41 des Messwertaufnehmers 1 elektrisch verbunden. Die gemeinsame Gegenelektrode 12, 12' und die Frequenzelektroden 22, 23 sind in genau einer Kontaktierungszone Z nahe der Schrägachse CC' für eine elektrische und mechanische Kontaktierung mit elektrischen Leitern einfach zugänglich. Der Messwertaufnehmer 1 benötigt nur drei elektrische Leiter für sechs Elektroden 12, 12', 13, 13', 22, 23.

In der dritten Ausführungsform nach Fig. 6, 7 ist eine Ladungselektrode 13 sowohl mit dem ersten piezoelektrischen Material 11 des piezoelektrischen Aufnehmerelementes 10 als auch mit dem piezoelektrischen Material 21 des Resonatorelementes 20 mechanisch und elektrisch verbunden. Die Ladungselektrode 13 ist elektrisch mit einer Frequenzelektrode 23 verbunden. Die beiden elektrisch miteinander verbundenen Elektroden 13, 23 dienen als gemeinsame elektrische Masse und werden auch Masseelektroden 13, 23 genannt. Eine Ladungselektrode 12 ist auf dem piezoelektrischen Material 11, 11' des piezoelektrischen Aufnehmerelementes 10 angeordnet und wird auch Gegenelektrode 12 genannt. Die Masseelektroden 13, 23, die Gegenelektrode 12 und die Frequenzelektrode 22 sind in genau einer Kontaktierungszone Z nahe der Schrägachse CC' für eine elektrische und mechanische Kontaktierung mit elektrischen Leitern einfach zugänglich. Der Messwertaufnehmer 1 benötigt nur drei elektrische Leiter für vier Elektroden 12, 13, 22, 23.

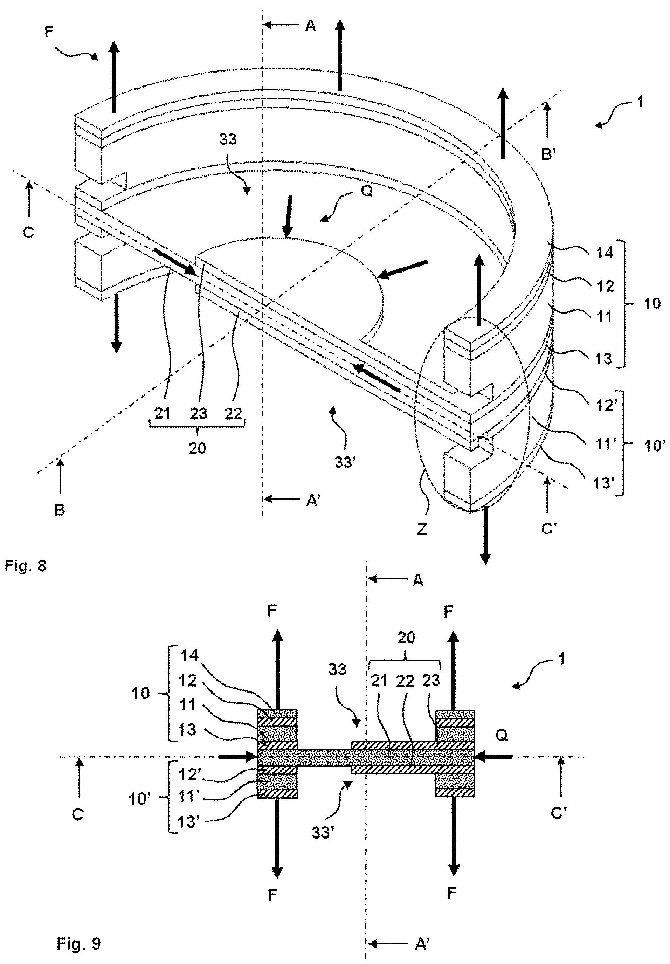

In der vierten Ausführungsform nach Fig. 8, 9 sind zwei Ladungselektroden 12', 13 mit dem piezoelektrischen Material 21 des Resonatorelementes 20 mechanisch verbunden. Die zwei Ladungselektroden 12', 13 sind auf verschiedenen Stirnflächen des piezoelektrischen Materials 21 angeordnet. Zwei Ladungselektroden 12, 13' sind auf dem piezoelektrischen Material 11, 11' der piezoelektrischen Aufnehmerelemente 10, 10' angeordnet. Eine mit dem piezoelektrischen Material 21 des Resonatorelementes 20 mechanisch verbundene Ladungselektrode 12' und eine auf dem ersten piezoelektrischen Material 11 des ersten piezoelektrischen Aufnehmerelementes 10 angeordnete Ladungselektrode 12 sind elektrisch miteinander verbunden und dienen als gemeinsame Gegenelektrode 12, 12'. Damit die beiden Gegenelektroden 12, 12' elektrische Polarisationsladungen mit gleichem Vorzeichen abgreifen, sind das erste piezoelektrische Material 11 des ersten piezoelektrischen Aufnehmerelementes 10 und das zweite piezoelektrische Material 11' des zweiten piezoelektrischen Aufnehmerelementes 10' mit gleicher Polarisationsrichtung zueinander angeordnet. Eine mit dem piezoelektrischen Material 21 des Resonatorelementes 20 mechanisch verbundene Ladungselektrode 13 und eine auf dem zweiten piezoelektrischen Material 11' des zweiten piezoelektrischen Aufnehmerelementes 10' angeordnete Ladungselektrode 13' sind elektrisch miteinander verbunden und dienen als elektrische Masse und werden auch Masseelektroden 13, 13' genannt. Die beiden Masseelementroden 13, 13' sind mit dem geerdeten Gehäuse 41 des Messwertaufnehmers 1 elektrisch verbunden. Die Masseelektrode 13, die Gegenelektrode 12' und die Frequenzelektroden 22, 23 sind in genau einer Kontaktierungszone Z nahe der Schrägachse CC' für eine elektrische und mechanische Kontaktierung mit elektrischen Leitern einfach zugänglich. Der Messwertaufnehmer 1 benötigt nur drei elektrische Leiter für sechs Elektroden 12, 12', 13, 13', 22, 23.

Ein Aufbau des Messwertaufnehmers 1 mit drei elektrischen Leitern für vier oder sechs Elektroden 12, 12', 13, 13', 22 und 23 ist platzsparend und macht eine Herstellung des Messwertaufnehmers 1 kostengünstig. Die elektrische und mechanische Kontaktierung der Elektroden 12, 12', 13, 13', 22, 23 in genau einer Kontaktierungszone Z mit elektrischen Leitern erfolgt mittels Stoffschluss und/oder Kraftschluss. Der Stoffschluss erfolgt durch Schweissen, diffusionsschweissen, Thermokompression, Löten, usw. Der Kraftschluss erfolgt durch Schraubverbindung, Klemmverbindung, usw. Bei Kenntnis der vorliegenden Erfindung kann der Fachmann die elektrische und mechanische Kontaktierung der Elektroden mit elektrischen Leitern auch in mehr als einer Kontaktierungszone realisieren.

In den Ausführungsformen nach Fig. 6 bis 9 weist der Messwertaufnehmer 1 ein elektrisches Isolationselement 14 auf. Das elektrische Isolationselement 14 ist hohlzylinderförmig. Das elektrische Isolationselement 14 besteht aus elektrisch isolierendem und mechanisch steifem Material wie Keramik, Al₂O₃-Keramik, Saphir, usw. Das elektrische Isolationselement 14 ist mechanisch mit einer Gegenelektrode 12 verbunden. Vorzugsweise erfolgt die mechanische Verbindung über Stoffschluss wie Schweissen, Diffusionsschweissen, Thermokompressionsbonden, Löten, usw. Solch eine stoffschlüssige Verbindung ist kostengünstig und mechanisch langzeitstabil.

Eine Verstärkung und Auswertung der Ladungssignale des piezoelektrischen Materials 11 des piezoelektrischen Aufnehmerelementes 10, 10' erfolgt in einer Auswerteeinheit. Dazu sind die Ladungselektroden 12, 12', 13, 13' des piezoelektrischen Aufnehmerelementes 10, 10' mit einer Verstärkerschaltung der Auswerteeinheit elektrisch verbunden. Eine Anregung des piezoelektrischen Materials 21 des Resonatorelementes 20 erfolgt über Frequenzsignale von der Auswerteeinheit. Dazu sind die Frequenzelektroden 22, 23 des Resonatorelementes 20 mit einer Oszillatorschaltung der Auswerteeinheit elektrisch verbunden. Die Frequenzänderung Δf wird mit der Oszillatorschaltung ermittelt. Die Auswerteeinheit bestimmt aus der ermittelten Frequenzänderung Δf die Querdehnung Q. Vorzugsweise ist die Oszillatorschaltung eine Colpitts-Schaltung. Typische Resonanzfrequenzen liegen im Bereich von einigen kHz bis mehreren MHz, typische Frequenzänderungen Δf liegen im Bereich von 2Hz/N bis 100Hz/N.

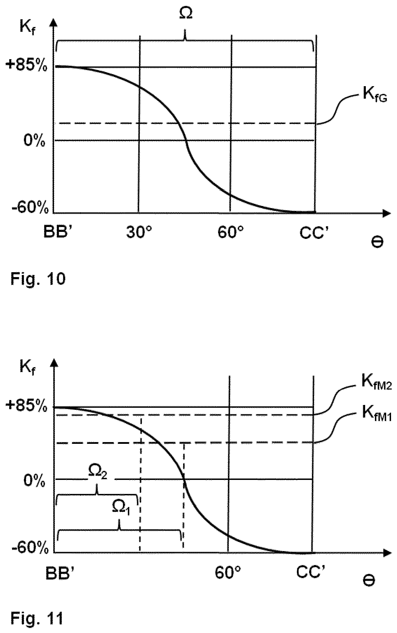

Die Fig. 10 und 11 zeigen die Kraftempfindlichkeit K_{f} in Abhängigkeit des Krafteinleitungswinkels θ. Diese Kraftempfindlichkeit K_{f} gilt für ein im Hohlraum 33, 33' schwingendes Resonatorelement 20 gemäss den Ausführungsformen nach Fig. 1 bis 9. Für einen Krafteinleitungswinkel θ entlang der Querachse BB' ist die Kraftempfindlichkeit K_{f} maximal und auf 100% normiert. Für einen Krafteinleitungswinkel θ von 45° bezüglich der Querachse BB' ist die Kraftempfindlichkeit K_{f} Null oder 0%. Für einen Krafteinleitungswinkel θ entlang der Schrägachse CC' ist die Kraftempfindlichkeit K_{f} minimal oder -60%.

Falls sich ein Krafteinleitungswinkelbereich Ω über 90° von der Querachse BB' hin zur Schrägachse CC' erstreckt, so ergibt nach Fig. 10 eine Summe der Kraftempfindlichkeiten K_{f} eine gesamte Kraftempfindlichkeit K_{fG} von 10%. In Fig. 11 wird nun ein Krafteinleitungswinkelbereich Ω eingeschränkt. Für einen ersten Krafteinleitungswinkelbereich Ω₁ über 45° von der Querachse BB' hin zur Schrägachse CC' ergibt die Summe der Kraftempfindlichkeiten K_{f} eine erste mittlere Kraftempfindlichkeit K_{fM1} von 50%. Für einen zweiten Krafteinleitungswinkelbereich Ω₂ über 30° von der Querachse BB' hin zur Schrägachse CC' ergibt die Summe der Kraftempfindlichkeiten K_{f} eine zweite mittlere Kraftempfindlichkeit K_{fM2} von 75%.

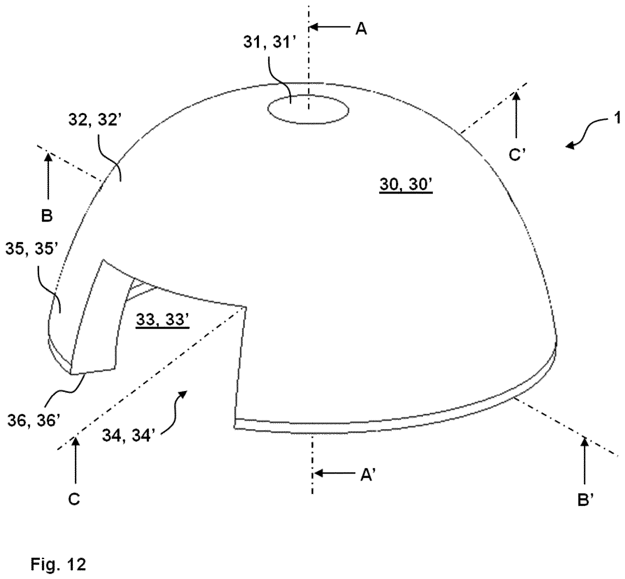

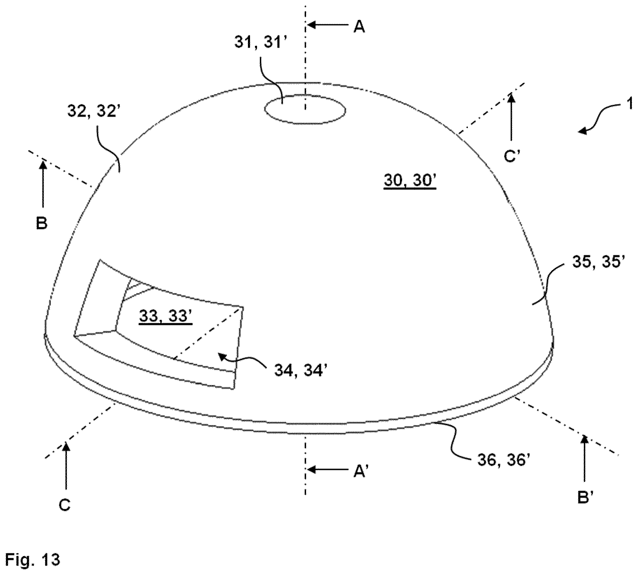

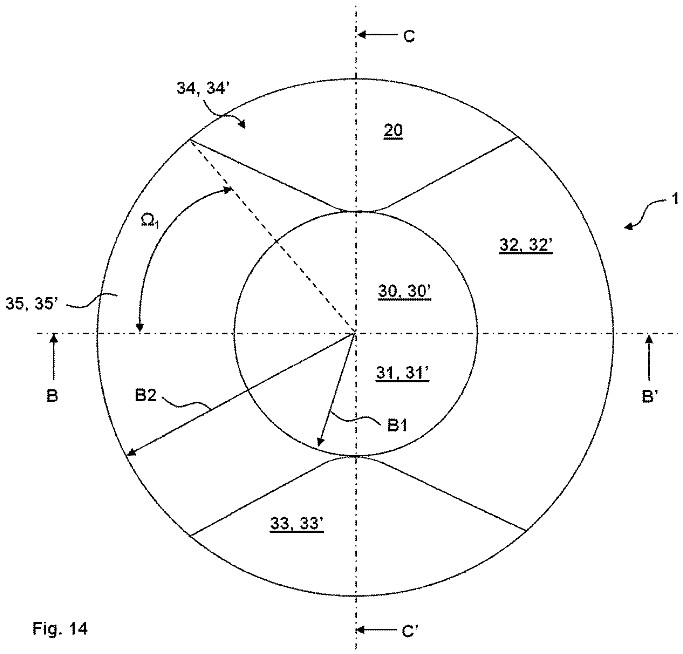

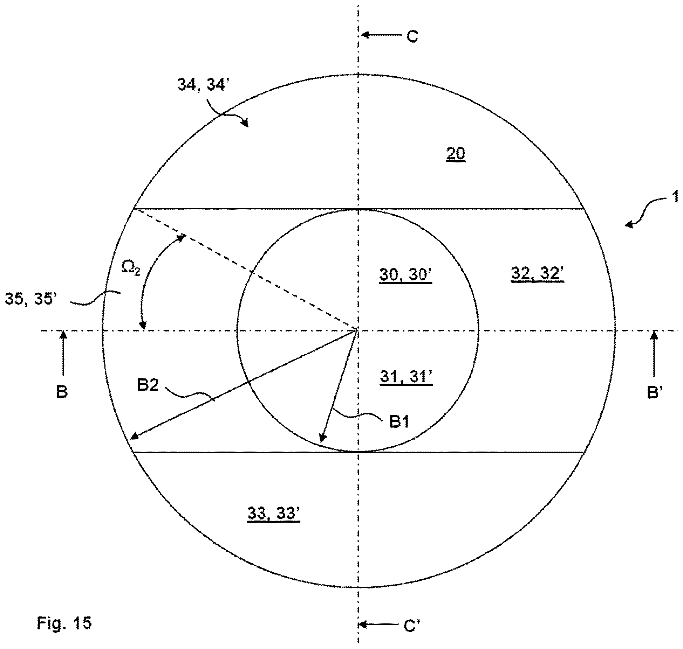

Eine optimale Einstellung des Krafteinleitungswinkelbereiches Ω lässt sich mit mindestens einem Kraftangriffselement 30, 30' erreichen. Die Kraft F greift am Kraftangriffselement 30, 30' an und wird vom Kraftangriffselement 30, 30' in das piezoelektrische Aufnehmerelement 10, 10' und das Resonatorelement 20 weitergeleitet. Die Fig. 12 und 13 zeigen in perspektivischer Ansicht eine erste und eine zweite Ausführungsform eines hohlkugelsegmentförmigen Kraftangriffselementes 30, 30'. Die Fig. 14 und 15 zeigen in Draufsicht eine dritte und eine vierte Ausführungsform eines hohlkegelstumpfförmigen Kraftangriffselementes 30, 30'. Das Kraftangriffselement 30, 30' kann auch hohlzylinderförmig, hohlpyramidenstumpfförmig, usw. sein. Das Kraftangriffselement 30, 30' besteht aus mechanisch steifem Material wie aus Reinmetallen, Nickellegierungen, Kobaltlegierungen, Eisenlegierungen, Keramik, usw.

Das Kraftangriffselement 30, 30' ist ein Hohlkörper, welcher eine Deckfläche 31, 31', eine Mantelfläche 32, 32' und einen Hohlraum 33, 33' aufweist. Das Resonatorelement 20 ist im Hohlraum 33, 33' angeordnet. Der Hohlraum 33, 33' erstreckt sich sowohl im Kraftangriffselement 30, 30' als auch im piezoelektrischen Aufnehmerelement 10, 10'. Deckfläche 31, 31' und Mantelfläche 32, 32' sind mechanisch miteinander verbunden und umschliessen den Hohlraum 33, 33'. Die Kraft F greift entlang der Längsachse AA' an der Deckfläche 31, 31' an und wird von der Deckfläche 31, 31' in die Mantelfläche 32, 32' weiterleitet. Die Mantelfläche 32, 32' weist mindestens einen ausgesparten Bereich 34, 34' auf, welcher bis zum Hohlraum 33, 33' reicht und das Weiterleiten der Kraft F in der Mantelfläche 32, 32' verhindert. Und die Mantelfläche 32, 32' weist mindestens einen nichtausgesparten Bereich 35, 35' auf, und nur der nichtausgesparte Bereich 35, 35' leitet die Kraft F weiter. Der Hohlkörper weist an einem von der Deckfläche 31, 31' abgewandten Ende eine Grundfläche 36, 36' auf. Deckfläche 31, 31' und Grundfläche 36, 36' sind über die Mantelfläche 32, 32' mechanisch miteinander verbunden. Deckfläche 31, 31', Mantelfläche 32, 32' und Grundfläche 36, 36' sind vorzugsweise einstückig. Deckfläche 31, 31' und Grundfläche 36, 36' liegen parallel zueinander in der Querebene BC. Der nichtausgesparte Bereich 35, 35' der Mantelfläche 32, 32' und die Grundfläche 36, 36' bilden in der Querebene BC mindestens einen Kraftweiterleitungswinkelbereich Ω, Ω₁, Ω₂.

Der ausgesparte Bereich 34, 34' ist vorzugsweise fensterförmig. In der Ausführungsform nach Fig. 12 ist der ausgesparte Bereich 34, 34' in einem bezüglich der Längsachse AA' unteren Bereich der Mantelfläche 32, 32' angeordnet. In der Ausführungsform nach Fig. 13 ist der ausgesparte Bereich 34, 34' in einem bezüglich der Längsachse AA' mittleren Bereich der Mantelfläche 32, 32' angeordnet. In den beiden Ausführungsformen nach Fig. 14 und 15 bildet der ausgesparte Bereich 34, 34' einen grossen Teil der Mantelfläche 32, 32'. In der dritten Ausführungsform nach Fig. 14 weist das Kraftangriffselement 30, 30' vier erste Krafteinleitungswinkelbereiche Ω₁ von jeweils 45° auf. In der vierten Ausführungsform nach Fig. 15 weist das Kraftangriffselement 30, 30' vier zweite Krafteinleitungswinkelbereiche Ω₂ von jeweils 30° auf. Jeweils zwei erste oder zweite Krafteinleitungswinkelbereiche Ω₁, Ω₂ sind durch einen ausgesparten Bereich 34, 34' begrenzt, so dass die Kraft F nur über die ersten oder zweiten Krafteinleitungswinkelbereiche Ω₁, Ω₂ weitergeleitet wird. Vorzugsweise weist jedes Kraftangriffselement 30, 30' zwei ausgesparte Bereiche 34, 34' auf, die bezüglich der Längsachse AA' im Winkel von 180° zueinander verdreht sind.

Der erste oder zweite Krafteinleitungswinkelbereich Ω₁, Ω₂ wird bereichsweise so begrenzt, dass in Summe eine mittlere Kraftempfindlichkeit K_{fM1}, K_{fM2} nahe am Maximum von 100% der Kraftempfindlichkeit K_{f} ist. Je kleiner der erste oder zweite Krafteinleitungswinkelbereich Ω₁, Ω₂ ist, desto grösser ist ein lokaler Druck im piezoelektrischen Aufnehmerelement 10, 10' und im Resonatorelement 20. Die Grösse des ersten oder zweiten Krafteinleitungswinkelbereiches Ω₁, Ω₂ und somit des lokalen Druckes im piezoelektrischen Aufnehmerelement 10, 10' und im Resonatorelement 20 lässt sich in Abhängigkeit der Druckfestigkeit des piezoelektrischen Aufnehmerelementes 10, 10' und des Resonatorelementes 20 wählen. Je druckfester das piezoelektrische Aufnehmerelement 10, 10' und das Resonatorelement 20 sind, desto kleiner kann der erste oder zweite Krafteinleitungswinkelbereich Ω₁, Ω₂ gewählt werden, und desto grösser ist die mittlere Kraftempfindlichkeit K_{fM1}, K_{fM2}.

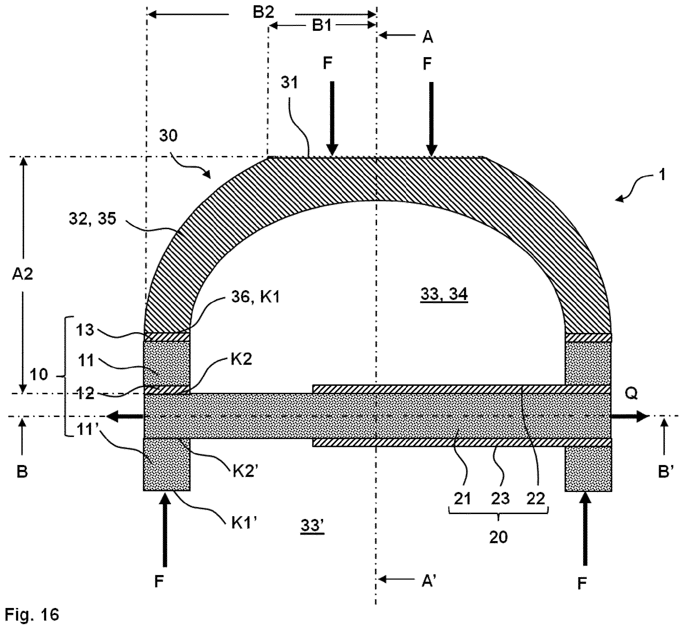

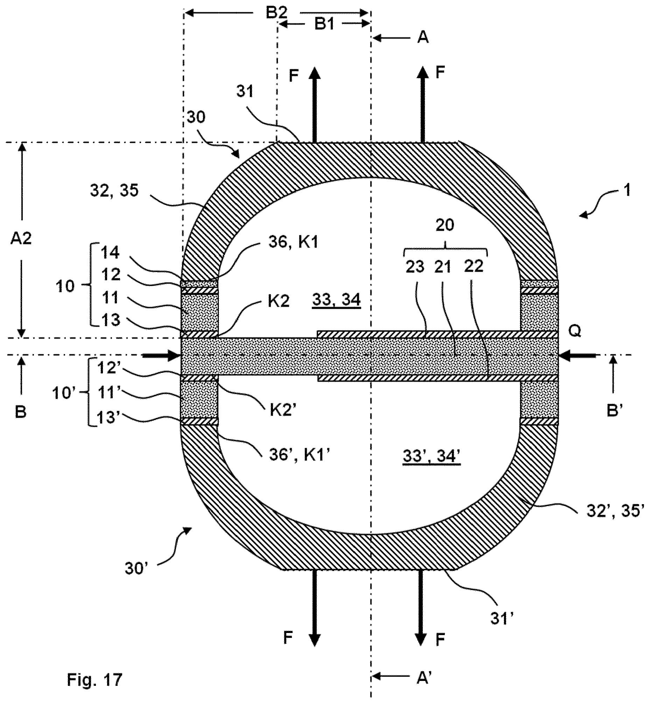

Fig. 16 zeigt einen Schnitt des Messwertaufnehmers 1 nach Fig. 2 und 3 mit einem Kraftangriffselement 30 nach Fig. 14 oder 15. Fig. 17 zeigt einen Schnitt des Messwertaufnehmers 1 nach Fig. 8 und 9 mit zwei Kraftangriffselementen 30, 30' nach Fig. 14 oder 15. Vorzugsweise sind die zwei Kraftangriffselemente 30, 30' Gleichteile, welche Gleichteile die Kraft F symmetrisch zum piezoelektrischen Aufnehmerelement 10, 10' und zum Resonatorelement 20 weiterleiten.

Das piezoelektrischen Aufnehmerelement 10, 10' und das Resonatorelement 20 sind mit der Mantelfläche 32, 32' mechanisch verbunden. Diese mechanische Verbindung ist vorzugsweise indirekt. So ist in den Ausführungsformen nach Fig. 16 und 17 das piezoelektrische Aufnehmerelement 10, 10' indirekt über den Aufnehmerkontaktbereich K1, K1' und die Grundfläche 36, 36' mechanisch mit dem Kraftangriffselement 30, 30' verbunden. Und auch das Resonatorelement 20 ist in den Ausführungsformen nach Fig. 16 und 17 indirekt über den Resonatorkontaktbereich K2, K2' mit dem piezoelektrischen Aufnehmerelement 10, 10' mechanisch verbunden, welches wiederum über den Aufnehmerkontaktbereich K1, K1' und die Grundfläche 36, 36' mechanisch mit dem Kraftangriffselement 30, 30' verbunden ist. Vorzugsweise erfolgt die mechanische Verbindung über Stoffschluss wie Schweissen, Diffusionsschweissen, Thermokompressionsbonden, Löten, usw.

Nach Fig. 16 greift die Kraft F sowohl an einem ersten Kraftangriffselement 30 als auch am piezoelektrischen Aufnehmerelement 10 an. Die Kraft F greift dabei einmal indirekt über das erste Kraftangriffselement 30 am piezoelektrischen Aufnehmerelement 10 an und sie greift einmal direkt über einen Aufnehmerkontaktbereich K1' am piezoelektrischen Aufnehmerelement 10. Nach Fig. 17 greift die Kraft F am ersten Kraftangriffselement 30 an und wird über eine erste Grundfläche 36 und den Aufnehmerkontaktbereich K1 in das erste piezoelektrische Aufnehmerelement 10 weitergeleitet und die Kraft F greift an einem zweiten Kraftangriffselement 30' an und wird über eine zweite Grundfläche 36' und den Aufnehmerkontaktbereich K1' in das zweite piezoelektrische Aufnehmerelement 10' weitergeleitet. Die Kraft F greift dabei zweimal indirekt über Kraftangriffselemente 30, 30' an piezoelektrischen Aufnehmerelementen 10, 10' an. Die Kraft F wird somit vom piezoelektrischen Aufnehmerelement 10, 10' in das Resonatorelement 20 weitergeleitet.

Deckfläche 31, 31' und Grundfläche 36, 36' liegen parallel zueinander in der Querebene BC. Die Längsachse AA' steht senkrecht auf der Querebene BC. Die Deckfläche 31, 31' ist vorzugsweise kreisförmig und weist einen konstanten Aussenradius oder maximalen Abstand B1 der Deckfläche 31, 31' zur Längsachse AA' auf. Die Grundfläche 36, 36' ist vorzugsweise kreisringförmig und weist einen konstanten Aussenradius oder maximalen Abstand B2 der Grundfläche 36, 36' zur Längsachse AA'. Der maximale Abstand B2 ist grösser als der maximale Abstand B1. Die Kraft F wird somit in der Mantelfläche 32, 32' von der Längsachse AA' weg weitergeleitet. Das Weiterleiten der Kraft F erfolgt in einem gekrümmten Abschnitt des nichtausgesparten Bereiches 35, 35' der Mantelfläche 32, 32'. Das Weiterleiten der Kraft F erfolgt von der Deckfläche 31, 31' zum Resonatorkontaktbereich K2, K2'. Mit A2 wird eine Länge entlang der Längsachse AA' von der Deckfläche 31, 31' zum Resonatorkontaktbereich K2, K2' bezeichnet. Die an der Deckfläche 31, 31' angreifende Kraft F verursacht im Resonatorelement 20 eine vergrösserte Querdehnung Q. Je grösser eine Differenz zwischen dem maximalen Abstand B2 und dem maximalen Abstand B1 ist, desto mehr vergrössert sich die Querdehnung Q. Mit der vergrösserten Querdehnung Q vergrössert sich auch die von der Kraft F erzeugte Frequenzänderung. Damit wird beim Messen der statischen Kraft unter Anwendung des inversen piezoelektrischen Effektes die im Markt geforderte hohe Empfindlichkeit erreicht.

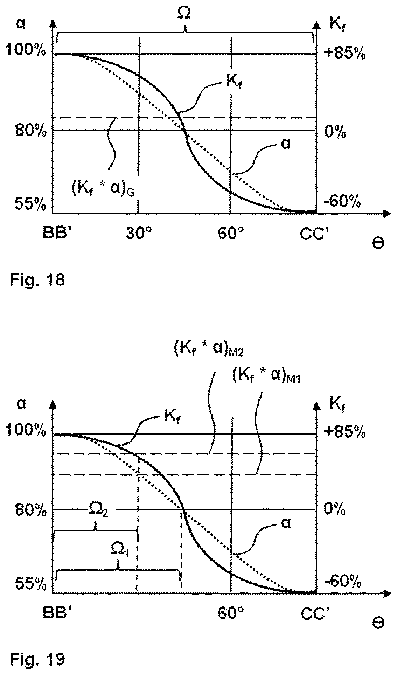

Die Abhängigkeit der Kraftempfindlichkeit K_{f} vom Krafteinleitungswinkel θ beeinflusst auch eine Grösse eines thermischen Längenausdehnungskoeffizienten α des piezoelektrischen Materials 11, 11', 21. Nach Fig. 18 ist der thermische Längenausdehnungskoeffizient α bei maximaler Kraftempfindlichkeit K_{f} mit einem Krafteinleitungswinkel θ entlang der Querachse BB' maximal und auf 100% normiert. Bei minimaler Kraftempfindlichkeit K_{f} mit einem Krafteinleitungswinkel θ entlang der Schrägachse CC' ist der thermische Längenausdehnungskoeffizient α des piezoelektrischen Materials 11, 11', 21 minimal und auf 55% normiert. Nach Fig. 18 resultiert im gesamten Krafteinleitungswinkelbereich Ω von 90° zwischen der Querachse BB' und der Schrägachse CC' Querachse BB' hin zur Schrägachse CC' in Summe ein gesamter thermischer Längenausdehnungskoeffizient (K_{f} * α)_{G}. Der gesamte thermische Längenausdehnungskoeffizient (K_{f} * α)_{G} ist das über alle Krafteinleitungswinkel θ aufsummierte Produkt von Kraftempfindlichkeit K_{f} mit dem thermischen Längenausdehnungskoeffizienten a. Wenn nun der Krafteinleitungswinkelbereich Ω eingeschränkt wird, ist ein in Summe resultierender mittlerer Längenausdehnungskoeffizient (K_{f} * α)_{M1}, (K_{f} * α)_{M2} des piezoelektrischen Materials 11, 11', 21 je nach Grösse eines ersten oder zweiten Krafteinleitungswinkelbereiches Ω₁, Ω₂ unterschiedlich gross. Nach Fig. 19 resultiert für einen ersten Krafteinleitungswinkelbereich Ω₁ über 45° von der Querachse BB' hin zur Schrägachse CC' in Summe ein erster mittlerer thermischer Längenausdehnungskoeffizient (K_{f} * α)_{M1}. Für einen zweiten Krafteinleitungswinkelbereich Ω₂ über 30° von der Querachse BB' hin zur Schrägachse CC' resultiert in Summe ein zweiter mittlerer thermischer Längenausdehnungskoeffizient (K_{f} * α)_{M2}.

Der Messwertaufnehmer 1 ist im Betrieb dauerhaft Temperaturen von 200°C und höher ausgesetzt. Dabei können sich das piezoelektrische Material 11, 11', 21 und das Kraftangriffselement 30, 30' unterschiedlich in der Länge ausdehnen. Das Kraftangriffselement 30, 30' hat einen thermischen Längenausdehnungskoeffizienten α₃₀. Um den thermischen Längenausdehnungskoeffizienten α₃₀ und mit den mittleren thermischen Längenausdehnungskoeffizienten (K_{f} * α)_{M1}, (K_{f} * α)_{M2} vergleichen zu können, werden die mittleren thermischen Längenausdehnungskoeffizienten (K_{f} * α)_{M1}, (K_{f} * α)_{M2} nach Fig. 19 mit den mittleren Kraftempfindlichkeiten K_{fM1}, K_{fM2} nach Fig. 11 gewichtet. Für den ersten Krafteinleitungswinkelbereich Ω₁ hat das piezoelektrische Material 11, 11', 21 einen ersten gewichteten thermischen Längenausdehnungskoeffizient α_{M1} = (K_{f} * α)_{M1} / K_{fM1}. Für den zweiten Krafteinleitungswinkelbereich Ω₂ hat das piezoelektrische Material 11, 11', 21 einen zweiten gewichteten thermischen Längenausdehnungskoeffizient α_{M2} = (K_{f} * α)₂ / K_{fM2}. Um die unterschiedliche Längenausdehnung des piezoelektrischen Materials 11, 11', 21 und des Kraftangriffselementes 30, 30' möglichst klein zu halten, ist der erste oder zweite gewichtete thermische Längenausdehnungskoeffizient α_{M1}, α_{M2} des piezoelektrischen Materials 11, 11', 21 weitgehend gleich dem thermischen Längenausdehnungskoeffizient α₃₀ des Kraftangriffselementes 30, 30'. Vorzugsweise wird Quarz als piezoelektrisches Material 11, 11', 21 verwendet, mit einem maximalen thermische Längenausdehnungskoeffizient α von 13.7 * 10⁻⁶ K⁻¹, was der 100%-Normierung in Fig. 18 und 19 entspricht und einem minimalen thermische Längenausdehnungskoeffizient α von 7.5 * 10⁻⁶ K⁻¹, was der 55%-Normierung in Fig. 18 und 19 entspricht. Ein Kraftangriffselement 30, 30' aus Stahl hat einen thermischen Längenausdehnungskoeffizienten α₃₀ von 13.0 * 10⁻⁶ K⁻¹. Für den ersten Krafteinleitungswinkelbereich Ω₁ = 45° hat das piezoelektrische Material 11, 11', 21 einen ersten gewichteten thermischen Längenausdehnungskoeffizient α_{M1} = 12 * 10⁻⁶ K⁻¹, für den zweiten Krafteinleitungswinkelbereich Ω₁ = 30° hat das piezoelektrische Material 11, 11', 21 einen zweiten gewichteten thermischen Längenausdehnungskoeffizient α_{M2} = 13 * 10⁻⁶ K⁻¹, welcher weitgehend gleich dem thermischen Längenausdehnungskoeffizienten α₃₀ des Kraftangriffselementes 30, 30' ist.

Das Resonatorelement 20 misst eine Temperatur T unter Anwendung des inversen piezoelektrischen Effektes. Die Resonanzfrequenz des piezoelektrischen Materials 21 des Resonatorelementes 20 ist von einer Temperatur T abhängig und lässt sich wie folgt formulieren: f (T) = 1/2d(T) * (e_{iλ}(T)/ρ(T))^{1/2}, wobei der piezoelektrische Modul e_{iλ}, eine Materialdicke d des piezoelektrischen Materials 21 und eine Dichte ρ von der Temperatur T abhängig sind. Mit Δf_{T} wird eine temperaturabhängige Frequenzänderung bezeichnet. Die Frequenzänderung Δf_{T} wird mit der Oszillatorschaltung der Auswerteeinheit ermittelt. Die Auswerteeinheit bestimmt aus der ermittelten temperaturabhängige Frequenzänderung Δf_{T} die Temperatur T. Vorzugsweise wird Quarz als piezoelektrisches Material 21 des Resonatorelementes 20 verwendet mit Resonanzfrequenzen im Bereich von einigen kHz bis mehreren MHz und einer temperaturabhängigen Frequenzänderung Δf_{T} im Bereich von 20Hz/K bis 200Hz/K.

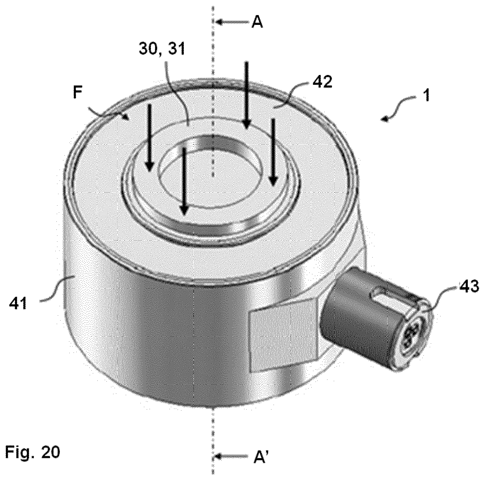

Fig. 20 zeigt den einsatzbereit montierten Messwertaufnehmer 1 nach Fig. 1 bis 9 mit einem Kraftangriffselement 30, 30' nach Fig. 14 bis 17. Der Messwertaufnehmer 1 ist in einem Gehäuse 41 unter Vakuum montiert. Das Gehäuse 41 ist zylinderförmig. Mindestens ein Kraftangriffselement 30, 30' ragt auf einer Stirnseite des Gehäuses 41 mit einer Deckfläche 31, 31' aus dem Gehäuse 41. Vorzugsweise ragen zwei Kraftangriffselemente 30, 30' auf zwei Stirnseiten des Gehäuses 41 mit je einer Deckfläche 31, 31' aus dem Gehäuse 41. In der Ansicht nach Fig. 20 ist nur eine Stirnseite dargestellt. Jede Stirnseite weist eine hohlzylinderförmige Abdeckung 42 auf. Gehäuse 41 und Abdeckung 42 schützen den Messwertaufnehmer 1 vor schädlichen äusseren Einflüssen wie Schmutz, Feuchtigkeit, mechanische Schläge, usw. Gehäuse 41 und Abdeckung 42 sind aus mechanisch beständigem Material wie aus Reinmetallen, Nickellegierungen, Kobaltlegierungen, Eisenlegierungen, usw. Das Kraftangriffselement 30, 30' ist mittels der Abdeckung 42 mit dem Gehäuse 41 mechanisch verbunden. Die Abdeckung 42 ist über einen bezüglich der Längsachse AA' radial äusseren Rand mit dem Gehäuse 41 mechanisch verbunden. Vorzugsweise erfolgt die mechanische Verbindung über Stoffschluss wie Schweissen, Diffusionsschweissen, Thermokompressionsbonden, Löten, usw. Die Abdeckung 42 ist über einen bezüglich der Längsachse AA' radial inneren Rand mit den Kraftangriffselementen 30, 30' mechanisch verbunden. Vorzugsweise erfolgt die mechanische Verbindung über Stoffschluss wie Schweissen, Diffusionsschweissen, Thermokompressionsbonden, Löten, usw. Für einen geringen Kraftnebenschluss zum Gehäuse 41 ist die Abdeckung 42 dünn, die Abdeckung 42 ist 0.3mm, vorzugsweise 0.2mm, vorzugsweise 0.1mm dünn. Je dünner die Abdeckung 42 ist, desto geringer ist der Kraftnebenschluss zum Gehäuse 41.

Ladungssignale der Ladungselektroden 12, 12', 13 und 13' sind über elektrische Leiter zu einem elektrischen Anschluss 43 an die Auswerteeinheit ableitbar. Frequenzsignale von der Auswerteeinheit sind über den elektrischen Anschluss 43 über elektrische Leiter an die Frequenzelektroden 22, 23 anlegbar. Die Auswerteeinheit ist über einen Stecker mit Kabel mit dem elektrischen Anschluss 43 elektrisch verbindbar. Der elektrische Anschluss 43 ist in einer Öffnung einer Seitenwand des Gehäuses 41 angeordnet. Der elektrische Anschluss 43 ist mit dem Gehäuse 41 mechanisch verbunden. Vorzugsweise erfolgt die mechanische Verbindung über Stoffschluss wie Schweissen, Diffusionsschweissen, Thermokompressionsbonden, Löten, usw.

Die elektrische und mechanische Kontaktierung der Elektroden 12, 12', 13, 13', 22 und 23 mit elektrischen Leitern ist in genau einer Kontaktierungszone Z einfach zu bewerkstelligen. Dazu wird der Messwertaufnehmer 1 nach Fig. 1 bis 9 bevor er in das Gehäuse 41 gesetzt wird mit abisolierten Enden der elektrischen Leiter elektrisch und mechanisch kontaktiert. Daraufhin wird der Messwertaufnehmer 1 in das Gehäuse 41 gesetzt und die mit dem Messwertaufnehmer 1 elektrisch und mechanisch kontaktierten elektrischen Leiter werden durch die Öffnung in der Seitenwand des Gehäuses 41 nach aussen geführt und elektrisch und mechanisch mittels Stoffschluss und/oder Kraftschluss mit dem elektrischen Anschluss 43 kontaktiert. Der Stoffschluss erfolgt durch Schweissen, diffusionsschweissen, Thermokompression, Löten, usw. Der Kraftschluss erfolgt durch Schraubverbindung, Klemmverbindung, usw.

Die mechanischen Verbindungen zwischen dem Gehäuse 41 und den Abdeckungen 42, zwischen den Abdeckungen 42 und den Kraftangriffselemente 30, 30', sowie zwischen dem Gehäuse 41 und dem elektrischen Anschluss 43 sind druckdicht.

### Bezugszeichenliste

- A2: Länge
- B1, B2: maximaler Abstand
- AA', BB', CC': Achse
- BC: Querebene
- K_{f}: Kraftempfindlichkeit
- K_{fG}: gesamte Kraftempfindlichkeit
- K_{fM1}, K_{fM2}: mittlere Kraftempfindlichkeit
- (K_{f}*α)_{G}: gesamter Längenausdehnungskoeffizient
- (K_{f}*α)_{M1}, (K_{f}*α)_{M2}: mittlerer Längenausdehnungskoeffizient
- F: Kraft
- Q: Querdehnung
- K1, K1': Aufnehmerkontaktbereich
- K2, K2': Resonatorkontaktbereich
- Z: Kontaktierungszone
- α: Längenausdehnungskoeffizient
- θ: Krafteinleitungswinkel
- Ω, Ω₁, Ω₂: Krafteinleitungswinkelbereich
- 1: Messwertaufnehmer
- 10, 10': piezoelektrisches Aufnehmerelement
- 11, 11', 21: piezoelektrisches Material
- 12, 12', 13, 13': Ladungselektrode
- 14: elektrisches Isolationselement
- 20: Resonatorelement
- 22, 23: Frequenzelektrode
- 30, 30': Kraftangriffselement
- 31, 31': Deckfläche
- 32, 32': Mantelfläche
- 33, 33': Hohlraum
- 34, 34': ausgesparter Bereich
- 35, 35': nichtausgesparter Bereich
- 36, 36': Grundfläche
- 41: Gehäuse
- 42: Abdeckung
- 43: elektrischer Anschluss

## Patentansprüche

1. Messwertaufnehmer (1) zum gleichzeitigen Messen einer dynamischen Kraft (F) mit Änderungsfrequenzen im Bereich von einigen Hz bis mehreren MHz und einer statischen Kraft (F), die sich über lange Zeiträume von Stunden, Wochen und Jahren nicht ändert; mit mindestens einem piezoelektrischen Aufnehmerelement (10, 10') zum Messen der dynamischen Kraft (F) direkt in einem Kraftfluss der dynamischen Kraft (F); wobei die dynamische Kraft (F) auf Elementflächen des piezoelektrischen Aufnehmerelementes (10, 10') elektrische Polarisationsladungen erzeugen kann, eine Menge der erzeugten elektrischen Polarisationsladungen ist proportional zu einer Grösse der dynamischen Kraft (F); mit einem Resonatorelement (20) zum Messen der statischen Kraft (F), welches Resonatorelement (20) zu mindestens einer Resonanzfrequenz (f) anregbar ist; wobei die dynamische Kraft (F) und die statische Kraft (F) in einer Kraftrichtung am piezoelektrischen Aufnehmerelement (10, 10') und am Resonatorelement (20) angreifen können; **dadurch gekennzeichnet, dass** das piezoelektrische Aufnehmerelement (10, 10') hohlzylinderförmig ist und ein hohlzylinderförmiges erstes piezoelektrisches Material (11) und ein hohlzylinderförmiges zweites piezoelektrisches Material (11') aufweist; dass das Resonatorelement (20) zylinderförmig ist und räumlich zwischen dem erstem piezoelektrischen Material (11) und dem zweitem piezoelektrischen Material (11') angeordnet ist; dass das Resonatorelement (20) die statische Kraft (F) in einem Schwingbereich ausserhalb des Kraftflusses der statischen Kraft (F) messen kann; dass die statische Kraft (F) im Resonatorelement (20) eine Querdehnung (Q) verursachen kann, die Querdehnung (Q) erfolgt im Resonatorelement (20) in einer Querrichtung, welche Querrichtung mit der Kraftrichtung einen von Null verschiedenen Winkel bildet, eine Grösse der Querdehnung (Q) ist proportional zur Grösse der statischen Kraft (F); und dass die Querdehnung (Q) eine Frequenzänderung (Δf) der Resonanzfrequenz (f) erzeugt, welche Frequenzänderung (Δf) eine Funktion der statischen Kraft (F) ist.

2. Messwertaufnehmer (1) nach Anspruch 1, **dadurch gekennzeichnet, dass** der Messwertaufnehmer (1) genau ein piezoelektrisches Aufnehmerelement (10) aufweist; dass das piezoelektrische Aufnehmerelement (10) ein erstes piezoelektrisches Material (11) und ein zweites piezoelektrisches Material (11') aufweist; und dass das Resonatorelement (20) räumlich zwischen erstem piezoelektrischen Material (11) und zweitem piezoelektrischen Material (11') angeordnet ist.

3. Messwertaufnehmer (1) nach Anspruch 1, **dadurch gekennzeichnet, dass** der Messwertaufnehmer (1) zwei piezoelektrische Aufnehmerelemente (10) aufweist; dass ein erstes piezoelektrisches Aufnehmerelement (10) ein erstes piezoelektrisches Material (11) aufweist; dass ein zweites piezoelektrisches Aufnehmerelement (10') ein zweites piezoelektrisches Material (11') aufweist; und dass das Resonatorelement (20) räumlich zwischen erstem piezoelektrischen Material (11) und zweitem piezoelektrischen Material (11') angeordnet ist.

4. Messwertaufnehmer (1) nach einem der Ansprüche 2 oder 3, **dadurch gekennzeichnet, dass** das piezoelektrische Aufnehmerelement (10, 10') für den direkten piezoelektrischen Effekt in Form des Longitudinaleffektes so orientiert ist, dass auf Elementflächen auf denen die dynamische Kraft (F) einwirken kann, auch elektrische Polarisationsladungen erzeugt werden; und dass das piezoelektrische Material (11, 11') so zur dynamischen Kraft (F) orientiert ist, dass es eine hohe Empfindlichkeit für den direkten piezoelektrischen Effekt hat.

5. Messwertaufnehmer (1) nach einem der Ansprüche 2 bis 4, **dadurch gekennzeichnet, dass** das erste piezoelektrische Material (11) hohlzylinderförmig ist und einen ersten Hohlraum (33) ausbildet; dass das zweite piezoelektrisches Material (11') hohlzylinderförmig ist und einen zweiten Hohlraum (33') ausbildet; und dass das Resonatorelement (20) in den Hohlräumen (33, 33') als Dickenschwinger oder als Längen- oder Dehnungsschwinger oder als Biegeschwinger oder als Flächenscherschwinger oder als Dickenscherschwinger schwingt.

6. Messwertaufnehmer (1) nach einem der Ansprüche 1 bis 5, **dadurch gekennzeichnet, dass** das piezoelektrische Aufnehmerelement (10, 10') erstes piezoelektrisches Material (11) und zweites piezoelektrisches Material (11') aufweist; und dass das Resonatorelement (20) piezoelektrisches Material (21) aufweist, welches gleich dem ersten piezoelektrische Material (11) und dem zweiten piezoelektrische Material (11') des piezoelektrischen Aufnehmerelementes (10, 10') ist.

7. Messwertaufnehmer (1) nach Anspruch 6, **dadurch gekennzeichnet, dass** das piezoelektrische Material (11, 11', 21) des piezoelektrischen Aufnehmerelementes (10, 10') und des Resonatorelementes (20) aus Quarz besteht; dass eine optische Achse des piezoelektrischen Materials (11, 11') des piezoelektrischen Aufnehmerelementes (10, 10') parallel zu einer optischen Achse des piezoelektrischen Materials (21) des Resonatorelementes (20) angeordnet ist; und dass das piezoelektrische Material (11, 11', 21) des piezoelektrischen Aufnehmerelementes (10, 10') und des Resonatorelementes (20) in einer Ebene senkrecht zur optischen Achse gleiche elastische und thermische Eigenschaften hat.

8. Messwertaufnehmer (1) nach Anspruch 7, **dadurch gekennzeichnet, dass** das piezoelektrische Material (11, 11', 21) des piezoelektrischen Aufnehmerelementes (10, 10') und des Resonatorelementes (20) aus Kristallmaterial einer Symmetrieklasse m, 32, 3m, 42m, 2m oder 23 besteht.

9. Messwertaufnehmer (1) nach einem der Ansprüche 6 bis 8, **dadurch gekennzeichnet, dass** eine Oszillatorschaltung ein elektrisches Wechselfeld an das piezoelektrische Material (21) des Resonatorelementes (20) anlegt, welches elektrische Wechselfeld das Resonatorelement (20) zu mindestens einer Resonanzfrequenz in einem Grundton und n Obertönen anregt; und dass eine Auswerteeinheit eine Frequenzänderung (Δf) der mechanischen Eigenfrequenz des piezoelektrischen Materials (21) des Resonatorelementes (20) ermittelten kann; und dass die Auswerteeinheit aus der ermittelten Frequenzänderung (Δf) die statische Kraft (F) bestimmt.

10. Messwertaufnehmer (1) nach einem der Ansprüche 6 bis 9, **dadurch gekennzeichnet, dass** eine Oszillatorschaltung ein elektrisches Wechselfeld an das piezoelektrische Material (21) des Resonatorelementes (20) anlegt, welches elektrische Wechselfeld das Resonatorelement (20) zu mindestens einer Resonanzfrequenz in einem Grundton und n Obertönen anregt; dass eine Auswerteeinheit eine temperaturabhängige Frequenzänderung (Δf_{T}) einer Resonanzfrequenz (f) des Resonatorelementes (20) ermittelt; und dass die Auswerteeinheit aus der ermittelten temperaturabhängige Frequenzänderung (Δf_{T}) eine Temperatur bestimmt.

11. Messwertaufnehmer (1) nach einem der Ansprüche 6 bis 10, **dadurch gekennzeichnet, dass** das die dynamische Kraft (F) auf Elementflächen des piezoelektrischen Aufnehmerelementes (10, 10') elektrische Polarisationsladungen erzeugen kann; und dass Ladungselektroden (12, 12', 13, 13') die elektrischen Polarisationsladungen abnehmen; dass Frequenzelektroden (22, 23) ein elektrisches Wechselfeld an das piezoelektrische Material (21) des Resonatorelementes (20) anlegen, welches elektrische Wechselfeld das Resonatorelement (20) zu mindestens einer Resonanzfrequenz in einem Grundton und n Obertönen anregt; und dass die Elektroden (12, 12', 13, 13', 22, 23) stoffschlüssig mit dem piezoelektrischen Material (11, 11', 21) des piezoelektrischen Aufnehmerelementes (10, 10') und des Resonatorelementes (20) verbunden sind.

12. Messwertaufnehmer (1) nach Anspruch 11, **dadurch gekennzeichnet, dass** das der Messwertaufnehmer (1) genau drei elektrische Leiter für die Ladungselektroden (12, 12', 13, 13') und die Frequenzelektroden (22, 23) aufweist; und dass die Ladungselektroden (12, 12', 13, 13') und die Frequenzelektroden (22, 23) in genau einer Kontaktierungszone (Z) mit den elektrischen Leitern elektrisch und mechanisch kontaktiert sind.

13. Messwertaufnehmer (1) nach einem der Ansprüche 1 bis 12, **dadurch gekennzeichnet, dass** der der Messwertaufnehmer (1) in einem Gehäuse (41) montiert ist; dass der Messwertaufnehmer (1) mindestens ein Kraftangriffselement (30, 30') aufweist; und dass das Kraftangriffselement (30, 30') auf einer Stirnseite des Gehäuses (41) mit einer Deckfläche (31, 31') aus dem Gehäuse (41) ragt.

14. Messwertaufnehmer (1) nach Anspruch 13, **dadurch gekennzeichnet, dass** das Kraftangriffselement (30, 30') mittels einer Abdeckung (42) mit dem Gehäuse (41) mechanisch verbunden ist; und dass die Abdeckung (42) für einen geringen Kraftnebenschluss zum Gehäuse (41) dünn ist, je dünner die Abdeckung (42) ist, desto geringer ist der Kraftnebenschluss zum Gehäuse (41).

## Claims

1. A measurement transducer (1) for simultaneously measuring a dynamic force (F) with rates of change in the range of several Hz up to several MHz and a static force (F), that shows no change even over long time periods of hours, weeks and years; comprising at least one piezoelectric transducer element (10, 10') for measuring the dynamic force (F) directly in the load path of the dynamic force (F); wherein the dynamic force (F) can generate electrical polarization charges on element surfaces of the piezoelectric transducer element (10, 10'), an amount of the generated electrical polarization charges being proportional to a magnitude of the dynamic force (F); comprising a resonator element (20) for measuring the static force (F), which resonator element (20) can be excited to at least one resonance frequency (f); wherein the dynamic force (F) and the static force (F) can act on the piezoelectric transducer element (10, 10') and on the resonator element (20) in a direction of force; **characterized in that** said piezoelectric transducer element (10, 10') is hollow cylindrical in shape and comprises a first piezoelectric material (11) that is hollow cylindrical in shape and a second piezoelectric material (11') that is hollow cylindrical in shape; **in that** said resonator element (20) is cylindrical in shape and spatially arranged between the first piezoelectric material (11) and the second piezoelectric material (11'); **in that** said resonator element (20) can measure the static force (F) in an oscillation area which lies outside the load path of the static force (F); **in that** said static force (F) can cause a transverse expansion (Q) in the resonator element (20), the transverse expansion (Q) occurs in the resonator element (20) in a transverse direction, which transverse direction forms an angle with the direction of force that is different from zero, a magnitude of the transverse expansion (Q) is proportional to the magnitude of the static force (F); and **in that** the transverse expansion (Q) causes a frequency change (Δf) of the resonance frequency (f), which frequency change (Δf) is a function of the static force (F).

2. The measurement transducer (1) according to claim 1, **characterized in that** the measurement transducer (1) comprises exactly one piezoelectric transducer element (10); the piezoelectric transducer element (10) comprises a first piezoelectric material (11) and a second piezoelectric material (11');and the resonator element (20) is spatially arranged between the first piezoelectric material (11) and the second piezoelectric material (11').

3. The measurement transducer (1) according to claim 1, **characterized in that** the measurement transducer (1) comprises two piezoelectric transducer elements (10); a first piezoelectric transducer element (10) comprises a first piezoelectric material (11); a second piezoelectric transducer element (10') comprises a second piezoelectric material (11'); and the resonator element (20) is spatially arranged between the first piezoelectric material (11) and the second piezoelectric material (11').

4. The measurement transducer (1) according to any of claims 2 or 3, **characterized in that** the piezoelectric transducer element (10, 10') is oriented for the direct piezoelectric effect in the form of the longitudinal effect to occur so that electrical polarization charges are generated on those element surfaces on which the dynamic force (F) can act; and the piezoelectric material (11, 11') is oriented with respect to the dynamic force (F) to have high sensitivity for the direct piezoelectric effect.

5. The measurement transducer (1) according to any of claims 2 to 4, **characterized in that** the first piezoelectric material (11) is hollow cylindrical in shape and forms a first cavity (33); the second piezoelectric material (11') is hollow cylindrical in shape and forms a second cavity (33'); and the resonator element (20) oscillates in the cavities (33, 33') as a thickness oscillator or as a longitudinal mode or expansion oscillator or as a flexural mode oscillator or as a face shear mode oscillator or as a thickness shear mode oscillator.

6. The measurement transducer (1) according to any of claims 1 to 5, **characterized in that** the piezoelectric transducer element (10, 10') comprises first piezoelectric material (11) and second piezoelectric material (11'); and the resonator element (20) comprises piezoelectric material (21) which is identical to the first piezoelectric material (11) and the second piezoelectric material (11') of the piezoelectric transducer element (10, 10').

7. The measurement transducer (1) according to claim 6, **characterized in that** the piezoelectric material (11, 11', 21) of the piezoelectric transducer element (10, 10') and the resonator element (20) consists of quartz; wherein an optical axis of the piezoelectric material (11, 11') of the piezoelectric transducer element (10, 10') is arranged parallel to an optical axis of the piezoelectric material (21) of the resonator element (20); and the piezoelectric material (11, 11', 21) of the piezoelectric transducer element (10, 10') and of the resonator element (20) has similar elastic and thermal properties in a plane perpendicular to the optical axis.

8. The measurement transducer (1) according to claim 7, **characterized in that** the piezoelectric material (11, 11', 21) of the piezoelectric transducer element (10, 10') and of the resonator element (20) is made of crystal material of an m, 32, 3m, 42m, 2m or 23 symmetry class.

9. The measurement transducer (1) according to any of claims 6 to 8, **characterized in that** an oscillator circuit applies an alternating electrical field to the piezoelectric material (21) of the resonator element (20), said alternating electrical field excites the resonator element (20) to at least one resonance frequency with a fundamental tone and n overtones; and an evaluation unit can detect a frequency change (Δf) of the mechanical natural frequency of the piezoelectric material (21) of the resonator element (20); and from the detected frequency change (Δf) the evaluation unit determines the static force (F).

10. The measurement transducer (1) according to any of claims 6 to 9, **characterized in that** an oscillator circuit applies an alternating electrical field to the piezoelectric material (21) of the resonator element (20), said alternating electrical field excites the resonator element (20) to at least one resonance frequency with a fundamental tone and n overtones; an evaluation unit detects a temperature-dependent frequency change (Δf_{T}) of a resonance frequency (f) of the resonator element (20); and from the detected temperature-dependent frequency change (Δf_{T}) the evaluation unit determines a temperature.

11. The measurement transducer (1) according to any of claims 6 to 10, **characterized in that** the dynamic force (F) can generate electrical polarization charges on element surfaces of the piezoelectric transducer element (10, 10'); and charge-receiving electrodes (12, 12', 13, 13') receive the electrical polarization charges; frequency electrodes (22, 23) apply an alternating electrical field to the piezoelectric material (21) of the resonator element (20), said alternating electrical field excites the resonator element (20) to at least one resonance frequency with a fundamental tone and n overtones; and the electrodes (12, 12', 13, 13', 22, 23) are connected to the piezoelectric material (11, 11', 21) of the piezoelectric transducer element (10, 10') and the resonator element (20) by material bonding.

12. The measurement transducer (1) according to claim 11, **characterized in that** the measurement transducer (1) comprises exactly three electrical conductors for the charge-receiving electrodes (12, 12', 13, 13') and the frequency electrodes (22, 23); and the charge-receiving electrodes (12, 12', 13, 13') and the frequency electrodes (22, 23) are electrically and mechanically contacted by the electrical conductors in exactly one contacting zone (Z) .

13. The measurement transducer (1) according to any of claims 1 to 12, **characterized in that** the measurement transducer (1) is mounted in a housing (41); the measurement transducer (1) comprises at least one force application element (30, 30'); and the force application element (30, 30') protrudes from the housing (41) with a top surface (31, 31') on an end face of the housing (41).

14. The measurement transducer (1) according to claim 13, **characterized in that** the force application element (30, 30') is mechanically connected to the housing (41) by means of a cover (42); wherein said cover (42) is thin to keep the force shunt to the housing (41) low, the thinner the cover (42), the smaller is the force shunt towards the housing (41).

## Revendications

1. Transducteur de mesure (1) pour mesurer simultanément une force dynamique (F) ayant des fréquences de variation dans la gamme allant de plusieurs Hz à plusieurs MHz, et une force statique (F) ne changeant pas pendant de longues périodes de temps de quelques heures, quelques semaines et quelques années; comprenant au moins un élément transducteur piézoélectrique (10, 10') pour mesurer ladite force dynamique (F) directement dans le flux de forces de la force dynamique (F); ladite force dynamique (F) étant capable de générer des charges de polarisation électrique sur des surfaces d'élément de l'élément transducteur piézoélectrique (10, 10') et une quantité desdites charges de polarisation électrique générées étant proportionnelle à une grandeur de la force dynamique (F); en outre comprenant un élément résonateur (20) pour mesurer ladite force statique (F); lequel élément résonateur (20) peut être excité à au moins une fréquence de résonance (f); dans lequel la force dynamique (F) et la force statique (F) sont capables d'agir sur l'élément transducteur piézoélectrique (10, 10') et l'élément résonateur (20) dans une direction de force; **caractérisé en ce que** l'élément transducteur piézoélectrique (10, 10') est en forme de cylindre creux et comprend un premier matériau piézoélectrique (11) en forme de cylindre creux et un second matériau piézoélectrique (11') en forme de cylindre creux; **en ce que** l'élément résonateur (20) est de forme cylindrique et disposé dans un espace entre le premier matériau piézoélectrique (11) et le second matériau piézoélectrique (11'); **en ce que** l'élément résonateur (20) est capable de mesurer la force statique (F) dans une plage d'oscillation en dehors du flux de forces de la force statique (F); **en ce que** ladite force statique (F) provoque une expansion transversale (Q) dans l'élément résonateur (20), ladite expansion transversale (Q) se produisant dans l'élément résonateur (20) dans une direction transversale, laquelle direction transversale forme un angle différent de zéro avec la direction de la force, dans lequel une grandeur de ladite expansion transversale (Q) est proportionnelle à la grandeur de la force statique (F); et **en ce que** l'expansion transversale (Q) provoque un changement de fréquence (Δf) de la fréquence de résonance (f), lequel changement de fréquence (Δf) est une fonction de la force statique (F).

2. Transducteur de mesure (1) selon la revendication 1, **caractérisé en ce que** ledit transducteur de mesure (1) comprend exactement un élément de transducteur piézoélectrique (10); **en ce que** ledit élément de transducteur piézoélectrique (10) comprend un premier matériau piézoélectrique (11) et un second matériau piézoélectrique (11'); et **en ce que** ledit élément résonateur (20) est disposé dans un espace entre le premier matériau piézoélectrique (11) et le second matériau piézoélectrique (11').

3. Transducteur de mesure (1) selon la revendication 1, **caractérisé en ce que** ledit transducteur de mesure (1) comprend deux éléments transducteurs piézoélectriques (10); **en ce qu'**un premier élément transducteur piézoélectrique (10) comprend un premier matériau piézoélectrique (11); **en ce qu'**un second élément transducteur piézoélectrique (10') comprend un second matériau piézoélectrique (11'); et **en ce que** l'élément résonateur (20) est disposé dans un espace entre le premier matériau piézoélectrique (11) et le second matériau piézoélectrique (11').

4. Transducteur de mesure (1) selon l'une quelconque des revendications 2 ou 3, **caractérisé en ce que** l'élément transducteur piézoélectrique (10, 10') est orienté pour que l'effet piézoélectrique direct sous la forme de l'effet longitudinal se produise de sorte que des charges de polarisation électrique sont générées sur des surfaces de l'élément sur lesquelles la force statique (F) peut agir; et **en ce que** le matériau piézoélectrique (11, 11') est orienté par rapport à la force dynamique (F) pour avoir une sensibilité élevée pour l'effet piézoélectrique direct.

5. Transducteur de mesure (1) selon l'une quelconque des revendications 2 à 4, **caractérisé en ce que** le premier matériau piézoélectrique (11) est en forme de cylindre creux et forme une première cavité (33); **en ce que** le second matériau piézoélectrique (11') est en forme de cylindre creux et forme une seconde cavité (33'); et **en ce que** l'élément résonateur (20) oscille dans lesdites cavités (33, 33') comme un oscillateur d'épaisseur ou longitudinal ou d'allongement ou de flexion ou de cisaillement de surface ou de cisaillement d'épaisseur.

6. Transducteur de mesure (1) selon l'une quelconque des revendications 1 à 5, **caractérisé en ce que** l'élément transducteur piézoélectrique (10, 10') comprend un premier matériau piézoélectrique (11) et un second matériau piézoélectrique (11'); et **en ce que** l'élément résonateur (20) comprend un matériau piézoélectrique (21) qui est identique au premier matériau piézoélectrique (11) et au second matériau piézoélectrique (11') de l'élément transducteur piézoélectrique (10, 10').

7. Transducteur de mesure (1) selon la revendication 6, **caractérisé en ce que** le matériau piézoélectrique (11, 11', 21) de l'élément transducteur piézoélectrique (10, 10') et de l'élément résonateur (20) est constitué de quartz; dans lequel un axe optique du matériau piézoélectrique (11, 11') de l'élément transducteur piézoélectrique (10, 10') est disposé parallèlement à un axe optique du matériau piézoélectrique (21) de l'élément résonateur (20); et **en ce que** le matériau piézoélectrique (11, 11', 21) de l'élément transducteur piézoélectrique (10, 10') et de l'élément résonateur (20) ont des propriétés élastiques et thermiques identiques dans un plan perpendiculaire à l'axe optique.

8. Transducteur de mesure (1) selon la revendication 7, **caractérisé en ce que** le matériau piézoélectrique (11, 11', 21) de l'élément transducteur piézoélectrique (10, 10') et de l'élément résonateur (20) est constitué d'un matériau cristallin d'une classe de symétrie m, 32, 3m, 42m, 2m ou 23.

9. Transducteur de mesure (1) selon l'une quelconque des revendications 6 à 8, **caractérisé en ce qu'**un circuit oscillateur applique un champ électrique alternatif au matériau piézoélectrique (21) de l'élément résonateur (20); lequel champ électrique alternatif excite l'élément résonateur (20) pour qu'il oscille à au moins une fréquence de résonance dans une fréquence fondamentale et n harmoniques; et **en ce qu'**une unité d'évaluation détecte un changement de fréquence (Δf) de la fréquence naturelle mécanique du matériau piézoélectrique (21) de l'élément résonateur (20); et **en ce qu'**à partir du changement de fréquence (Δf) détecté, l'unité d'évaluation détermine ladite force statique (F).

10. Transducteur de mesure (1) selon l'une quelconque des revendications 6 à 9, **caractérisé en ce qu'**un circuit oscillateur applique un champ électrique alternatif au matériau piézoélectrique (21) de l'élément résonateur (20); lequel champ électrique alternatif excite l'élément résonateur (20) pour qu'il oscille à au moins une fréquence de résonance dans une fréquence fondamentale et n harmoniques; **en ce qu'**une unité d'évaluation détecte un changement de fréquence dépendant de la température (Δf_{T}) d'une fréquence de résonance (f) de l'élément résonateur (20); et **en ce qu'**à partir du changement de fréquence dépendant de la température (Δf_{T}) détecté, l'unité d'évaluation détermine une température.

11. Transducteur de mesure (1) selon l'une quelconque des revendications 6 à 10, **caractérisé en ce que** la force dynamique (F) génère des charges de polarisation électrique sur des surfaces d'élément de l'élément transducteur piézoélectrique (10, 10'); et **en ce que** des électrodes de charge (12, 12', 13, 13') reçoivent lesdites charges de polarisation électrique; **en ce que** des électrodes de fréquence (22, 23) appliquent un champ électrique alternatif au matériau piézoélectrique (21) de l'élément résonateur (20); lequel champ électrique alternatif excite l'élément résonateur (20) pour qu'il oscille à au moins une fréquence de résonance dans une fréquence fondamentale et n harmoniques; et **en ce que** les électrodes (12, 12', 13, 13', 22, 23) sont reliées au matériau piézoélectrique (11, 11', 21) de l'élément transducteur piézoélectrique (10, 10') et de l'élément résonateur (20) par une liaison matérielle.

12. Transducteur de mesure (1) selon la revendication 11, **caractérisé en ce que** le transducteur de mesure (1) comprend exactement trois conducteurs électriques pour les électrodes de charge (12, 12', 13, 13') et les électrodes de fréquence (22, 23); et **en ce que** lesdites électrodes de charge (12, 12', 13, 13') et lesdites électrodes de fréquence (22, 23) sont en contact électrique et mécanique avec lesdits conducteurs électriques dans exactement une zone de contact (Z).

13. Transducteur de mesure (1) selon l'une quelconque des revendications 1 à 12, **caractérisé en ce que** le transducteur de mesure (1) est installé dans un boîtier (41); **en ce que** le transducteur de mesure (1) comprend au moins un élément d'application de force (30, 30'); et **en ce que** ledit élément d'application de force (30, 30') fait saillie dudit boîtier (41) sur une face frontale du boîtier (41) avec une surface supérieure (31, 31') de l'élément d'application de force (30, 30').

14. Transducteur de mesure (1) selon la revendication 13, **caractérisé en ce que** l'élément d'application de force (30, 30') est relié mécaniquement au boîtier (41) au moyen d'un couvercle (42); et **en ce que** ledit couvercle (42) est mince pour une dérivation de force faible vers le boîtier (41); plus le couvercle (42) est mince, plus le dérivation de force vers le boîtier (41) est faible.
